# EUROPEAN PATENT APPLICATION

(11) **EP 4 675 626 A1**
(43) Date of publication of application: **07.01.2026**
(21) Application number: 25168173.0
(22) Date of filing: 03.04.2025
(51) Int. Cl.: G11C 16/04, G11C 16/08

(54) **MEMORY DEVICE INCLUDING A PLURALITY OF GROUND SELECTION TRANSISTORS**

(30) Priority: 04.07.2024 KR 20240088387; 27.08.2024 KR 20240115419; 26.02.2025 US 202519064418
(71) Applicant: Samsung Electronics Co., Ltd., Suwon-si, Gyeonggi-do 16677 (KR)
(72) Inventor: LEE, Taeyun, 16677 Suwon-si, Gyeonggi-do (KR); PARK, Sang-Won, 16677 Suwon-si, Gyeonggi-do (KR); PARK, Il Han, 16677 Suwon-si, Gyeonggi-do (KR)
(74) Representative: Kuhnen & Wacker Patent- und Rechtsanwaltsbüro PartG mbB

(57) **Abstract**

An example memory device includes a substrate, and a first cell string and a second cell string on the substrate between a first bit line and a common source line. The first cell string includes a first string selection transistor connected to a first string selection line and first and third ground selection transistors connected to first and second ground selection lines, respectively. The second cell string includes a second string selection transistor connected to a second string selection line and second and fourth ground selection transistors connected to the first and second ground selection lines, respectively. When the first cell string is a selected cell string, in the second cell string, the second and fourth ground selection transistors are turned off, and at least one ground selection transistor between the second and fourth ground selection transistors is turned on.

## Description

### CROSS-REFERENCE TO RELATED APPLICATIONS

This application claims priority under 35 U.S.C. § 119 to Korean Patent Application Nos. 10-2024-0088387 filed on July 4, 2024, and 10-2024-0115419 filed on August 27, 2024, in the Korean Intellectual Property Office, the disclosures of which are incorporated by reference herein in their entirety.

### BACKGROUND

A semiconductor memory is classified as a volatile memory, which loses data stored therein when a power is turned off, such as a static random access memory (SRAM) or a dynamic random access memory (DRAM) or a nonvolatile memory, which retains data stored therein even when a power is turned off, such as a flash memory, a phase-change RAM (PRAM), a magnetic RAM (MRAM), a resistive RAM (RRAM), or a ferroelectric RAM (FRAM).

The flash memory device is widely used as a high-capacity storage medium. In general, the flash memory device stores data or read the stored data by controlling levels of various lines (e.g., a string selection line, a word line, and a ground selection line) connected to a plurality of memory cells. When various lines are controlled individually in units of cell string, the reliability and performance of the flash memory device may be improved, but it is difficult to form lines individually due to increased complexity of the process of manufacturing the flash memory device.

### SUMMARY

The present disclosure relates to a memory device including a plurality of ground selection transistors with improved performance and improved reliability.

In general, according to some aspects, a memory device includes a substrate, a first cell string provided on the substrate between a first bit line and a common source line and including a first string selection transistor connected to a first string selection line, and a second cell string provided on the substrate between the first bit line and the common source line and including a second string selection transistor connected to a second string selection line. The first cell string further includes a first ground selection transistor connected to a first ground selection line, and a third ground selection transistor connected to a second ground selection line and physically spaced apart from the first ground selection transistor. The second cell string further includes a second ground selection transistor connected to the first ground selection line, and a fourth ground selection transistor connected to the second ground selection line and physically spaced apart from the second ground selection transistor. When the first cell string is a selected cell string, in the second cell string, the second and fourth ground selection transistors are turned off, and at least one ground selection transistor between the second and fourth ground selection transistors is turned on.

In general, according to some aspects, a memory device includes a substrate, a first cell string provided between a first bit line and a common source line and including a first string selection transistor connected to a first string selection line and a plurality of first ground selection transistors connected to a plurality of ground selection lines, wherein the plurality of first ground selection transistors are stacked on the substrate, and a second cell string provided between the first bit line and the common source line and including a second string selection transistor connected to a second string selection line and a plurality of second ground selection transistors connected to the plurality of ground selection lines. The plurality of second ground selection transistors are stacked on the substrate. When the first cell string is a selected cell string, a first on-voltage is applied to a first ground selection line and a second ground selection line among the plurality of ground selection lines, ground selection transistors connected to the first and second ground selection lines from among the plurality of second ground selection transistors are turned off by the first on-voltage of the first and second ground selection lines, and at least one ground selection transistor between ground selection transistors connected to the first and second ground selection lines from among the plurality of second ground selection transistors is turned on.

In general, according to some aspects, a memory device includes a substrate, a plurality of lower ground selection lines stacked on the substrate, upper ground selection lines stacked on the lower ground selection lines, and a plurality of cell strings connected between a first bit line and a common source line. Each of the plurality of cell strings includes a plurality of lower ground selection transistors connected to the lower ground selection lines, and a plurality of upper ground selection transistors connected to the upper ground selection lines. When a first cell string among the plurality of cell strings is a selected cell string, a first on-voltage is applied to at least one lower ground selection line among the plurality of lower ground selection lines, and the first on-voltage is applied to at least one upper ground selection line among the plurality of upper ground selection lines. When the first cell string is the selected cell string, in each of remaining cell strings among the plurality of cell strings other than the first cell string, at least one lower ground selection transistor connected to the at least one lower ground selection line from among the plurality of lower ground selection transistors is turned off, at least one upper ground selection transistor connected to the at least one upper ground selection line from among the plurality of upper ground selection transistors is turned off, and ground selection transistors between the at least one lower ground selection transistor and the at least one upper ground selection transistor are turned on.

In general, according to some aspects, a memory device includes a substrate, and a first cell string provided on the substrate between a first bit line and a common source line and including a first string selection transistor connected to a first string selection line and a plurality of ground selection transistors connected to a plurality of ground selection lines. When the first cell string is an unselected cell string, at least two ground selection transistors spaced apart from each other from among the plurality of ground selection transistors are turned off.

In general, according to some aspects, a memory device includes a substrate, and a plurality of cell strings provided on the substrate between a first bit line and a common source line and each including a plurality of ground selection transistors connected to a plurality of ground selection lines. When a first cell string among the plurality of cell strings is a selected cell string, in remaining unselected cell strings among the plurality of cell strings, at least two ground selection transistors among the plurality of ground selection transistors are turned off. In each of the unselected cell strings, at least one ground selection transistor between at least two ground selection transistors among the plurality of ground selection transistors is turned on.

### BRIEF DESCRIPTION OF THE DRAWINGS

The above and other objects and features of the present disclosure will become apparent by describing in detail implementations thereof with reference to the accompanying drawings.
FIG. 1 is a block diagram illustrating an example of a memory device.
FIG. 2 is a circuit diagram illustrating an example of a first memory block included in a memory cell array of FIG. 1.
FIG. 3 is a plan view of an example of a first memory block of FIG. 2.
FIGS. 4A, 4B, and 4C are diagrams for describing an example of a method of controlling a first memory block of FIGS. 2 and 3.
FIG. 5 is a diagrams illustrating an example of a ground selection transistor (GST) coding pattern (GCP) of ground selection transistors of a first memory block of FIG. 2.
FIGS. 6A, 6B, 6C, and 6D are diagrams for describing an example of an operation of a memory block including ground selection transistors programmed depending on the GST coding pattern of FIG. 5.
FIG. 7 is a flowchart illustrating an example of an operation of a memory device of FIG. 1.
FIGS. 8, 9, 10, 11, 12, 13, 14, and 15 are diagrams for describing an example of a GST coding pattern for ground selection transistors of a memory block of FIG. 2.
FIGS. 16A, 16B, 17A, and 17B are diagrams for describing an example of a GST coding pattern for ground selection transistors of a memory block of FIG. 2.
FIG. 18 is a block diagram illustrating an example of a memory system.
FIG. 19 is a diagram illustrating an example of a system to which a storage device is applied.

### DETAILED DESCRIPTION

Below, implementations of the present disclosure will be described in detail and clearly to such an extent that an ordinary one in the art easily carries out the present disclosure.

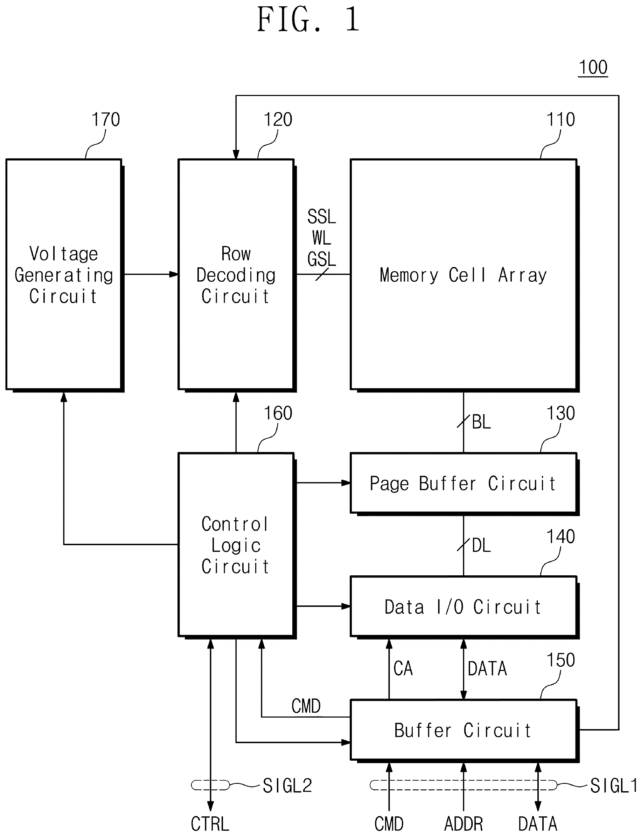

FIG. 1 is a block diagram illustrating an example of a memory device. Referring to FIG. 1, a memory device 100 may include a memory cell array 110, a row decoding circuit 120, a page buffer circuit 130, a data input/output circuit 140, a buffer circuit 150, a control logic circuit 160, and a voltage generating circuit 170. In some implementations, the memory device 100 may be a NAND flash memory. However, the present disclosure is not limited, and the memory device 100 may be one of various different memory devices.

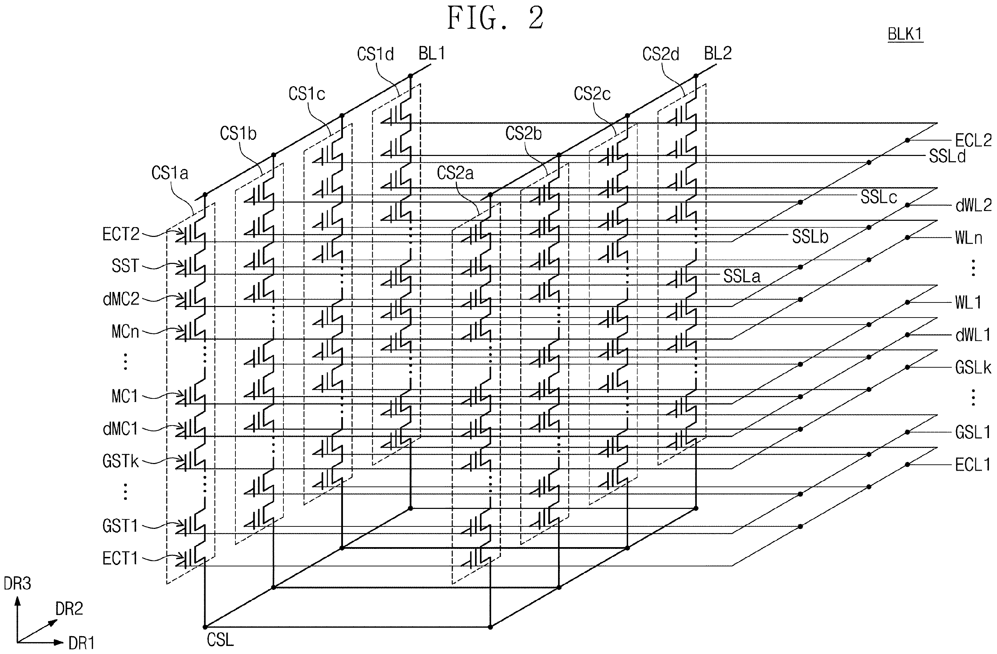

The memory cell array 110 may include a plurality of memory blocks. Each of the plurality of memory blocks may include a plurality of cell strings. Each of the plurality of cell strings may include a plurality of cell transistors stacked in a direction perpendicular to a substrate. The plurality of cell transistors may be connected in series between bit lines BL and a common source line. The plurality of cell transistors may be connected to string selection lines SSL, word lines WL, and ground selection lines GSL. The plurality of memory blocks will be described in detail with reference to FIG. 2.

The row decoding circuit 120 may be connected to the memory cell array 110 through the string selection lines SSL, the word lines WL, and the ground selection lines GSL. The row decoding circuit 120 may operate under control of the control logic circuit 160. For example, under control of the control logic circuit 160, the row decoding circuit 120 may decode a row address RA received from the buffer circuit 150; based on a decoding result, the row decoding circuit 120 may control or drive the string selection lines SSL, the word lines WL, and the ground selection lines GSL or may control voltages to be applied to the string selection lines SSL, the word lines WL, and the ground selection lines GSL.

The page buffer circuit 130 may be connected to the memory cell array 110 through the bit lines BL. The page buffer circuit 130 may be connected to the data input/output circuit 140 through a plurality of data lines DL. The page buffer circuit 130 may operate under control of the control logic circuit 160. For example, in the program operation of the memory device 100, the page buffer circuit 130 may store data to be programmed in the memory cell array 110 under control of the control logic circuit 160. In the read operation of the memory device 100, the page buffer circuit 130 may sense voltages of the bit lines BL and may store the sensed voltages as read data.

The data input/output circuit 140 may be connected to the page buffer circuit 130 through the plurality of data lines DL. The data input/output circuit 140 may receive a column address CA from the buffer circuit 150. The data input/output circuit 140 may transmit the data read by the page buffer circuit 130 to the buffer circuit 150 depending on the column Address CA. The data input/output circuit 140 may transmit the data received from the buffer circuit 150 to the page buffer circuit 130, based on the column address CA.

The buffer circuit 150 may receive a command CMD and an address ADDR from an external device (e.g., a controller) through first signal lines SIGL1 and may exchange data "DATA" with the external device (e.g., a controller) through the first signal lines SIGL1. In some implementations, the first signal lines SIGL1 may include data signal lines (e.g., DQ lines) and a data strobe signal line (e.g., a DQS line).

The buffer circuit 150 may operate under control of the control logic circuit 160. For example, the control logic circuit 160 may exchange a control signal CTRL with the external device (e.g., a controller) through second signal lines SIGL2. The control logic circuit 160 may control the buffer circuit 150 based on the control signals CTRL such that the buffer circuit 150 routes the command CMD, the address ADDR, and the data "DATA". Under control of the control logic circuit 160, the buffer circuit 150 may classify signals received through the first signal lines SIGL1 as the command CMD or the address ADDR. The buffer circuit 150 may transfer the command CMD to the control logic circuit 160. The buffer circuit 150 may transfer the row address RA of the address ADDR to the row decoding circuit 120 and may transfer the column address CA of the address ADDR to the data input/output circuit 140. The buffer circuit 150 may exchange the data "DATA" with the data input/output circuit 140.

The control logic circuit 160 may decode the command CMD received from the buffer circuit 150 and may control the memory device 100 or various components of the memory device 100 based on a decoding result.

Under control of the control logic circuit 160, the voltage generating circuit 170 may generate various operating voltages VOP which are used in the memory device 100. In some implementations, the operating voltages VOP may include various voltages such as program voltages, pass voltages, selection read voltages, non-selection read voltages, erase voltages, and verify voltages. Below, various voltages which are used to describe implementations of the present disclosure may be include in the operating voltages VOP generated by the voltage generating circuit 170.

FIG. 2 is a circuit diagram illustrating an example of a first memory block included in a memory cell array of FIG. 1. A structure of a first memory block BLK1 will described with reference to FIG. 2, but the present disclosure is not limited thereto. For example, the memory cell array 110 may include a plurality of memory blocks, each of which is similar in structure to the first memory block BLK1 of FIG. 2.

In some implementations, the first memory block BLK1 to be described with reference to FIG. 2 may correspond to a physical erase unit of the memory device 100. However, the present disclosure is not limited thereto. For example, the memory device 100 may perform the erase operation in units of page, word line, sub-block, or plane.

In some implementations, the first memory block BLK1 to be described with reference to FIG. 2 is provided only as an example. The number of cell strings may increase or decrease, and the number of rows of cell strings and the number of columns of cell strings may increase or decrease depending on the number of cell strings. Also, the number of cell transistors GST, GST, MC, DMC, and SST of the first memory block BLK1 may increase or decrease, and the height of the first memory block BLK1 may increase or decrease depending on the number of cell transistors. In addition, the number of lines GSL, WL, DWL, and SSL connected to the cell transistors may increase or decrease depending on the number of cell transistors.

Referring to FIGS. 1 and 2, the first memory block BLK1 may include a plurality of cell strings CS1a, CS1b, CS1c, CS1d, CS2a, CS2b, CS2c, and CS2d. The plurality of cell strings CS1a to CS2d may be disposed along a first direction DR1 and a second direction DR2 to form rows and columns.

The plurality of cell strings CS1a to CS2d may be connected to bit lines BL1 and BL2. For example, each of the bit lines BL1 and BL2 may extend along the second direction DR2. The cell strings CS1a, CS1b, CS1c, and CS1d located at the same column, that is, the first column from among the plurality of cell strings CS1a to CS2d may be connected to the first bit line BL1, and the cell strings CS2a, CS2b, CS2c, and CS2d located at the same column, that is, the second column from among the plurality of cell strings CS1a to CS2d may be connected to the second bit line BL2.

The 1a-th cell string CS1a may include a plurality of cell transistors connected in series between the first bit line BL1 and a common source line CSL. The plurality of cell transistors of the 1a-th cell string CS1a located at the first column and first row may include a first erase control transistor ECT1, a plurality of ground selection transistors GST1 to GSTk, dummy memory cells dMC1 and dMC2, a plurality of memory cells MC1 to MCn, a string selection transistor SST, and a second erase control transistor ECT2. In some implementations, each of the plurality of cell transistors may be implemented with a charge trap flash (CTF) memory cell.

The plurality of cell transistors of the 1a-th cell string CS1a may be connected in series and may be stacked in a third direction DR3 (or a height direction) which is a direction perpendicular to a plane defined by the first direction DR1 and the second direction DR2 or a substrate. For example, the plurality of memory cells MC1 to MCn may be connected in series and may be stacked in the third direction DR3 being a direction perpendicular to the substrate. The string selection transistor SST may be provided between the plurality of memory cells MC1 to MCn and the first bit line BL1. The plurality of ground selection transistors GST1 to GSTk may be connected in series and may be stacked in the third direction DR3 (or a height direction) being a direction perpendicular to the substrate. The plurality of ground selection transistors GST1 to GSTk connected in series may be provided between the plurality of serially-connected memory cells MC1 to MCn and the common source line CSL.

In some implementations, the first dummy memory cell dMC1 may be provided between the plurality of memory cells MC1 to MCn and the plurality of ground selection transistors GST1 to GSTk. In some implementations, the second dummy memory cell dMC2 may be provided between the plurality of memory cells MC1 to MCn and the string selection transistor SST.

In some implementations, the first erase control transistor ECT1 may be provided between the plurality of ground selection transistors GST1 to GSTk and the common source line CSL. The second erase control transistor ECT2 may be provided between the string selection transistor SST and the first bit line BL1. The first and second erase control transistors ECT1 and ECT2 may be used to charge the channel of the 1a-th cell string CS1a with an erase voltage or to erase the first memory block BLK1, based on a gate induced drain leakage (GIDL) phenomenon.

For convenience of description, the structure of the 1a-th cell string CS1a is described, but the present disclosure is not limited thereto. For example, each of the remaining cell strings CS1b to CS1d and CS2a to CS2d may be similar in structure to the 1a-th cell string CS1a.

The first erase control transistors ECT1 of the plurality of cell strings CS1a to CS2d may be connected in common to a first erase control line ECL1. The second erase control transistors ECT2 of the plurality of cell strings CS1a to CS2d may be connected in common to a second erase control line ECL2.

Memory cells located at the same height from the substrate from among the plurality of memory cells MC1 to MCn may be connected in common to the same word line, and memory cells located at another height from among the plurality of memory cells MC1 to MCn may be connected in common to another word line. For example, the first memory cells MC1 of the plurality of cell strings CS1a to CS2d may be located at the same height from the substrate and may be connected in common to a first word line WL1. The n-th memory cells MCn of the plurality of cell strings CS1a to CS2d may be located at the same height from the substrate and may be connected in common to an n-th word line WLn.

In some implementations, the first dummy memory cells dMC1 of the plurality of cell strings CS1a to CS2d may be located at the same height from the substrate and may be connected in common to a first dummy word line dWL1. The second dummy memory cells dMC2 of the plurality of cell strings CS1a to CS2d may be located at the same height from the substrate and may be connected in common to a second dummy word line dWL2.

The string selection transistors SST of the plurality of cell strings CS1a to CS2d may be connected to a plurality of string selection lines SSLa to SSLd. For example, string selection transistors located at the same row may be connected to the same string selection line, and string selection transistors located at different rows may be connected to different string selection lines. In detail, the string selection transistors SST of the cell strings CS1a and CS2a located at the first row may be connected to an a-th string selection line SSLa; the string selection transistors SST of the cell strings CS1b and CS2b located at the second row may be connected to a b-th string selection line SSLb; the string selection transistors SST of the cell strings CS1c and CS2c located at the third row may be connected to a c-th string selection line SSLc; and, the string selection transistors SST of the cell strings CS1d and CS2d located at the fourth row may be connected to a d-th string selection line SSLd.

For brevity of drawing and for convenience of description, the description will be given as each of the plurality of cell strings CS1a to CS2d includes one string selection transistor SST, but the present disclosure is not limited thereto. Each of the plurality of cell strings CS1a to CS2d may include a plurality of string selection transistors, and string selection transistors located at the same row from among string selection transistors located at the same height from the substrate may be connected to the same string selection line; in this case, string selection transistors located at different rows may be connected to different string selection lines.

Ground selection transistors located at the same height from the substrate may be connected to the same ground selection line. For example, first ground selection transistors GST1 of the plurality of cell strings CS1a to CS2d may be located at the same height from the substrate and may be connected in common to a first ground selection line GSL1. k-th ground selection transistors GSTk of the plurality of cell strings CS1a to CS2d may be located at the same height from the substrate and may be connected in common to a k-th ground selection line GSLk.

As illustrated in FIG. 2, the plurality of cell strings CS1a to CS2d may be connected in common to the ground selection lines GSL1 to GSLk or may share the ground selection lines GSL1 to GSLk. In this case, as the plurality of cell strings CS1a to CS2d are controlled by the same ground selection line, a ground selection transistor of an unselected cell string may be turned on during the read operation, the verify operation, or the channel recovery operation, thereby causing issues such as the reduction of reliability, the reduction of performance, and an increase in power consumption.

To solve the above issues, the ground selection transistors GST1 to GSTk of the plurality of cell strings CS1a to CS2d may be connected to a ground selection line in units of row such that the plurality of cell strings CS1a to CS2d are controlled individually or in units of row. In this case, a ground selection transistor of an unselected cell string may be turned off during the read operation, the verify operation, or the channel recovery operation, and thus, issues such as the reduction of reliability, the reduction of performance, and an increase in power consumption may be solved.

However, the physical limitation of the first memory block BLK1 may make it difficult (or impossible) to implement a structure in which the ground selection transistors GST1 to GSTk of the plurality of cell strings CS1a to CS2d are connected to a ground selection line in units of row. In this case, the plurality of cell strings CS1a to CS2d may be individually controlled by individually setting a threshold voltage of each of the ground selection transistors GST1 to GSTk of the plurality of cell strings CS1a to CS2d and controlling voltages of the plurality of ground selection lines GSL1 to GSLk.

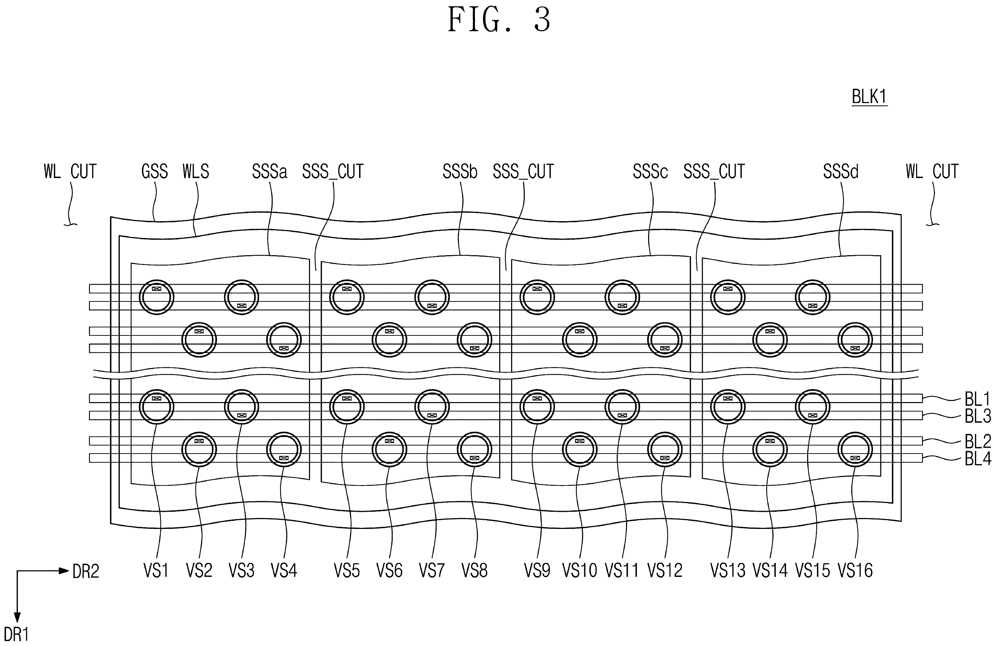

FIG. 3 is a plan view of an example of a first memory block of FIG. 2. For convenience of description, some components of the first memory block BLK1 are omitted. However, the present disclosure is not limited thereto. Referring to FIGS. 2 and 3, the first memory block BLK1 may be formed on the substrate. The first memory block BLK1 may include a ground selection structure GSS, a word line structure WLS, and a plurality of string selection structures SSSa, SSSb, SSSc, and SSSd. The ground selection structure GSS, the word line structure WLS, and the plurality of string selection structures SSSa, SSSb, SSSc, and SSSd may be provided between word line cuts WL_CUT and may be stacked along a direction (e.g., the third direction DR3) perpendicular to the substrate defined by the first direction DR1 and the second direction DR2.

The plurality of string selection structures SSSa, SSSb, SSSc, and SSSd may extend along the first direction DR1 and may be electrically separated from each other by string selection cuts SS_CUT. The first memory block BLK1 may include a plurality of vertical structures VS1 to VS16. The plurality of vertical structures VS1 to VS16 may penetrate the ground selection structure GSS, the word line structure WLS, and the plurality of string selection structures SSSa, SSSb, SSSc, and SSSd. For example, the first to fourth vertical structures VS1 to VS4 may penetrate the ground selection structure GSS, the word line structure WLS, and the a-th string selection structure SSSa; the fifth to eighth vertical structures VS5 to VS8 may penetrate the ground selection structure GSS, the word line structure WLS, and the b-th string selection structure SSSb; the ninth to twelfth vertical structures VS9 to VS12 may penetrate the ground selection structure GSS, the word line structure WLS, and the c-th string selection structure SSSc; and, the thirteenth to sixteenth vertical structures VS13 to VS16 may penetrate the ground selection structure GSS, the word line structure WLS, and the d-th string selection structure SSSd.

The plurality of vertical structures VS1 to VS16 may be connected to a plurality of bit lines BL1, BL2, BL3, and BL4 extending along the second direction DR2. For example, the first, fifth, ninth, and thirteenth vertical structures VS1, VS5, VS9, and VS13 may be connected to the first bit line BL 1; the second, sixth, tenth, and fourteenth vertical structures VS2, VS6, VS10, and VS14 may be connected to the second bit line BL2, the third, seventh, eleventh, and fifteenth vertical structures VS3, VS7, VS11, and VS15 may be connected to the third bit line BL3, and the fourth, eighth, twelfth, and sixteenth vertical structures VS4, VS8, VS12, and VS16 may be connected to the fourth bit line BL4.

In some implementations, each of the plurality of vertical structures VS1 to VS16 may form a cell string. For example, the first and second vertical structures VS1 and VS2 of FIG. 3 may respectively correspond to the 1a-th and 2a-th cell strings CS1a and CS2a of FIG. 2; the fifth and sixth vertical structures VS5 and VS6 of FIG. 3 may respectively correspond to the 1b-th and 2b-th cell strings CS1b and CS2b of FIG. 2; the ninth and tenth vertical structures VS9 and VS10 of FIG. 3 may respectively correspond to the 1c-th and 2c-th cell strings CS1c and CS2c of FIG. 2; and, the thirteenth and fourteenth vertical structures VS13 and VS14 of FIG. 3 may respectively correspond to the 1d-th and 2d-th cell strings CS1d and CS2d of FIG. 2.

In the structure of the first memory block BLK1 described with reference to FIG. 3, four string selection structures SSSa to SSSd may respectively correspond to four string selection lines SSLa to SSLd of FIG. 2. That is, in the first memory block BLK1 described with reference to FIG. 3, cell strings connected to four string selection lines SSLa to SSLd may share ground selection lines. Below, for convenience of description, an SSL-GSL structure of the first memory block BLK1 described with reference to FIGS. 2 and 3 may be referred to as a "4SSL-1GSL structure". This may indicate a structure where cell strings connected to four string selection lines share one ground selection line.

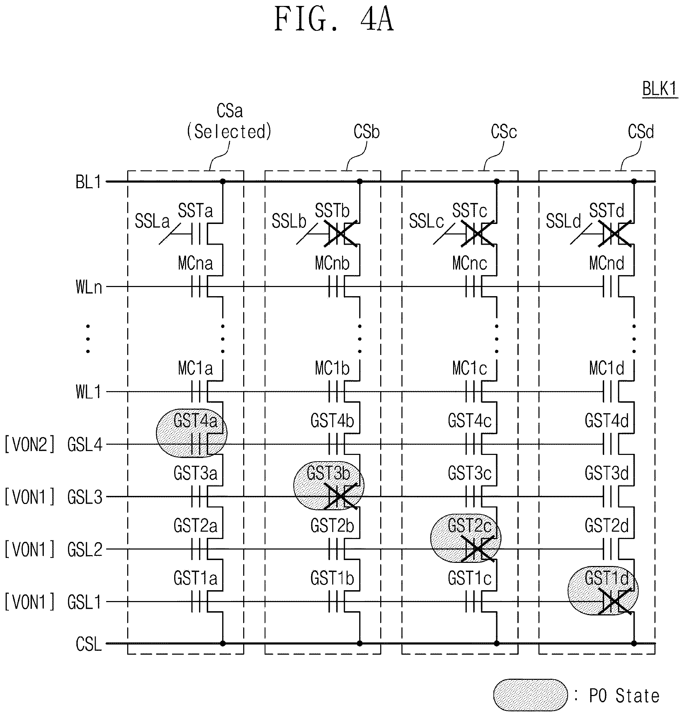

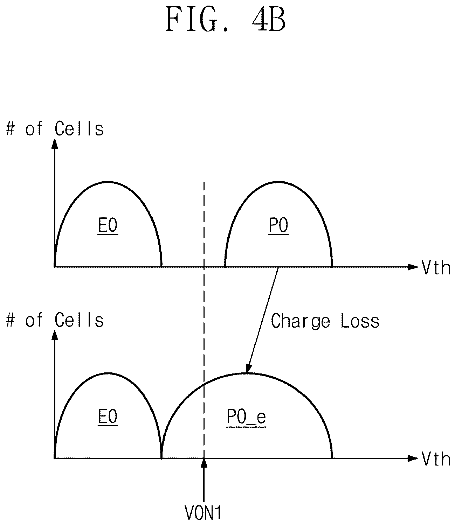

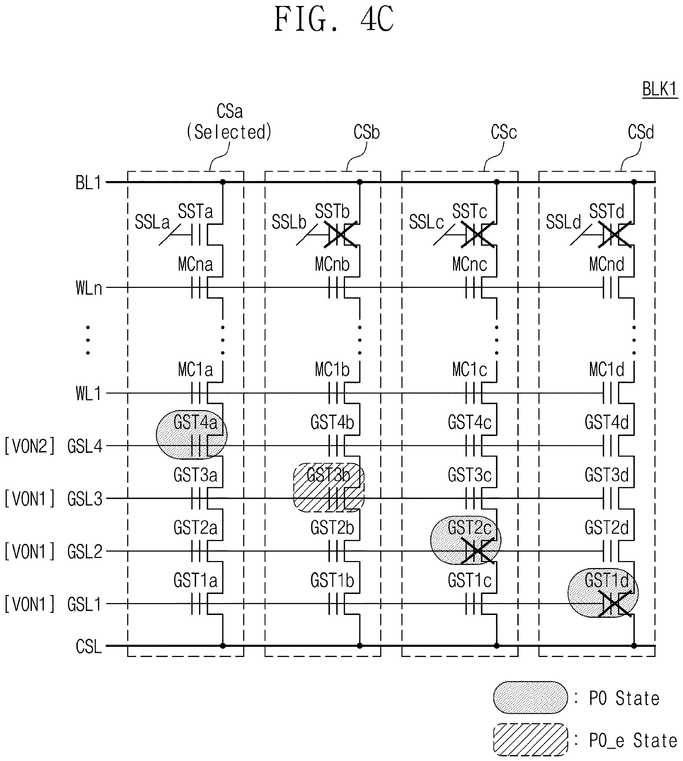

FIGS. 4A, 4B, and 4C are diagrams for describing an example of a method of controlling a first memory block of FIGS. 2 and 3. Below, for convenience of description, implementations of the present disclosure will be described based on the plurality of cell strings CSa, CSb, CSc, and CSd connected to the first bit line BL1. Also, some (e.g., dummy memory cells and erase control transistors) of cell transistors included in each of the plurality of cell strings CSa, CSb, CSc, and CSd are omitted. However, the present disclosure is not limited thereto.

Below, for brevity of drawing and for convenience of description, some ground selection lines GSL and some ground selection transistors GST are illustrated in a drawing, but the present disclosure is not limited thereto. For example, in the following drawings, ground selection transistors or dummy ground selection transistors are illustrated as being directly connected to the common source line CSL, but additional ground selection transistors may further exist between the ground selection transistors or the dummy ground selection transistors and the common source line CSL.

Below, for convenience of description, it is assumed that the first memory block BLK1 has the 4SSL-1GSL structure. That is, the first memory block BLK1 may include four cell strings connected to one bit line BL and sharing ground selection lines GSL, and the four cell strings may be respectively connected to individual string selection lines. However, the present disclosure is not limited thereto.

Referring to FIGS. 1 to 4C, the first memory block BLK1 may include the a-th to d-th cell strings CSa to CSd. Each of the a-th to d-th cell strings CSa to CSd may be connected between the first bit line BL1 and the common source line CSL. The a-th cell string CSa may include a plurality of ground selection transistors GST1a to GST4a, a plurality of memory cells MC1a to MCna, and an a-th string selection transistor SSTa. The b-th cell string CSb may include a plurality of ground selection transistors GST1b to GST4b, a plurality of memory cells MC1b to MCnb, and a b-th string selection transistor SSTb. The c-th cell string CSc may include a plurality of ground selection transistors GST1c to GST4c, a plurality of memory cells MC1c to MCnc, and a c-th string selection transistor SSTc. The d-th cell string CSd may include a plurality of ground selection transistors GST1d to GST4d, a plurality of memory cells MC1d to MCnd, and a d-th string selection transistor SSTd.

The string selection transistors SSTa of the a-th cell string CSa may be connected to the a-th string selection line SSLa; the string selection transistors SSTb of the b-th cell string CSb may be connected to the b-th string selection line SSLb; the string selection transistors SSTc of the c-th cell string CSc may be connected to the c-th string selection line SSLc; and, the string selection transistors SSTd of the d-th cell string CSd may be connected to the d-th string selection line SSLd.

The ground selection transistors GST1a to GST4a, GST1b to GST4b, GST1c to GST4c, and GST1d to GST4d and the memory cells MC1a to MCna, MC1b to MCnb, MC1c to MCnc, and MC1d to MCnd of the a-th to d-th cell strings CSa to CSd may be connected to the plurality of ground selection lines GSL1 to GSL4 and the plurality of word lines WL1 to WLn. For example, the first memory cells MC1a, MC1b, MC1c, and MC1d of the a-th to d-th cell strings CSa to CSd may be connected to the first word line WL1, and the n-th memory cells MCna, MCnb, MCnc, and MCnd of the a-th to d-th cell strings CSa to CSd may be connected to the n-th word line WLn.

The ground selection transistors GST1a, GST1b, GST1c, and GST1d of the a-th to d-th cell strings CSa to CSd may be connected to the first ground selection line GSL1; the ground selection transistors GST2a, GST2b, GST2c, and GST2d of the a-th to d-th cell strings CSa to CSd may be connected to the second ground selection line GSL2; the ground selection transistors GST3a, GST3b, GST3c, and GST3d of the a-th to d-th cell strings CSa to CSd may be connected to the third ground selection line GSL3; and, the ground selection transistors GST4a, GST4b, GST4c, and GST4d of the a-th to d-th cell strings CSa to CSd may be connected to the fourth ground selection line GSL4.

In some implementations, while the memory device 100 operates, one of the plurality of cell strings CSa to CSd may be selected, and the remaining cell strings may not be selected. In this case, a threshold voltage of each of the plurality of ground selection transistors GST1a to GST4d may be set such that the remaining unselected cell strings among the plurality of cell strings CSa to CSd other than the selected cell string are not electrically connected to the common source line CSL.

For example, as illustrated in FIG. 4B, a threshold voltage or a threshold voltage distribution of a 0-th program state P0 may be higher than a threshold voltage or a threshold voltage distribution of a 0-th erase state E0. In this case, a ground selection transistor having the 0-th program state P0 may be turned off by a first on-voltage VON1 and may be turned on by a second on-voltage VON2. A ground selection transistor with the 0-th erase state E0 may be turned on by the first on-voltage VON1 and may be turned on by the second on-voltage VON2.

In some implementations, the threshold voltage distribution of the 0-th erase state E0 may be different from the threshold voltage distribution of the 0-th program state P0. The 0-th erase state E0 may indicate a threshold voltage distribution lower than the threshold voltage distribution of the 0-th program state P0. For example, threshold voltages of ground selection transistors corresponding to the 0-th erase state E0 may be lower than threshold voltages of ground selection transistors corresponding to the 0-th program state P0. In some implementations, the threshold voltages of the ground selection transistors corresponding to the 0-th erase state E0 may be different from threshold voltages of memory cells MC corresponding to an erase state.

The threshold voltages of 4a-th, 3b-th, 2c-th, and 1d-th ground selection transistors GST4a, GST3b, GST2c, and GST1d among the plurality of ground selection transistors GST1a to GST4a may be set to the 0-th program state P0. In this case, as the first and second on-voltages VON1 and VON2 are applied to the plurality of ground selection lines GSL1 to GSL4, the remaining unselected cell strings among the plurality of cell strings CSa to CSd other than the selected cell string may not be electrically connected to the common source line CSL.

In detail, it is assumed that the a-th cell string CSa is a selected cell string. In this case, a first voltage V1 may be applied to the a-th string selection line SSLa, and an off voltage VOFF may be applied to the remaining string selection lines SSLb, SSLc, and SSLd. According to the above condition, the a-th string selection transistor SSTa of the a-th cell string CSa may be turned on, and the string selection transistors SSTb, SSTc, and SSTd of the remaining cell strings CSb, CSc, and CSd may be turned off.

In this case, the first on-voltage VON1 may be applied to the first to third ground selection lines GSL1 to GSL3, and the second on-voltage VON2 may be applied to the fourth ground selection line GSL4. As the first on-voltage VON1 is applied to the first ground selection line GSL1, the 1a-th, 1b-th, and 1c-th ground selection transistors GST1a, GST1b, and GST1c may be turned on, and the ground selection transistor GST1d may be turned off. As the first on-voltage VON1 is applied to the second ground selection line GSL2, the 2a-th, 2b-th, and 2d-th ground selection transistors GST2a, GST2b, and GST2d may be turned on, and the ground selection transistor GST2c may be turned off. As the first on-voltage VON1 is applied to the third ground selection line GSL3, the 3a-th, 3c-th, and 3d-th ground selection transistors GST3a, GST3c, and GST3d may be turned on, and the ground selection transistor GST3b may be turned off. As the second on-voltage VON2 is applied to the fourth ground selection line GSL4, the ground selection transistors GST4a, GST4b, GST4c, and GST4d connected to the fourth ground selection line GSL4 may be turned on.

That is, according to the above bias condition associated with the ground selection lines GSL1 to GSL4, because all the ground selection transistors GST1a to GST4a of the a-th cell string CSa being the selected cell string are turned on, the a-th cell string CSa may be electrically connected to the common source line CSL. In contrast, because the 3b-th, 2c-th, and 1d-th ground selection transistors GST3b, GST2c, and GST1d are turned off, the b-th, c-th, and d-th cell strings CSb, CSc, and CSd being the unselected cell strings may be electrically separated from the common source line CSL. Accordingly, issues, which may occur during the operation of the memory device 100, such as the reduction of reliability, the reduction of performance, and the increase in power consumption may be prevented.

In some implementations, the threshold voltages of the plurality of ground selection transistors GST1a to GST4d may be changed due to various factors. For example, as illustrated in FIG. 4B, as the charge loss occurs at the ground selection transistor of the 0-th program state P0, a threshold voltage may decrease. In this case, the 0-th program state P0 of the ground selection transistor may be changed to a 0-th error program state P0_e. Because the 0-th error program state P0_e is lower than the first on-voltage VON1, the ground selection transistor of the 0-th error program state P0_e may be turned on by the first on-voltage VON1. In this case, even though unintended, the unselected cell string may be electrically connected to the common source line CSL.

For example, as illustrated in FIG. 4C, it is assumed that the 3b-th ground selection transistor GST3b has the 0-th error program state P0_e. Under the above condition, when the a-th cell string CSa is a selected cell string, the first on-voltage VON1 may be applied to the first to third ground selection lines GSL1 to GSL3, and the second on-voltage VON2 may be applied to the fourth ground selection line GSL4. Because the 3b-th ground selection transistor GST3b has the 0-th error program state P0_e, the 3b-th ground selection transistor GST3b may be turned on by the first on-voltage VON1 of the third ground selection line GSL3. In this case, because the b-th cell string CSb being an unselected cell string is electrically connected to the common source line CSL, the reliability and performance of the memory device 100 may be reduced.

As described above, as the threshold voltages of the ground selection transistors of the memory device 100 are differently set, each cell string may be selectively electrically connected to the common source line CSL. In this case, when the threshold voltages of the ground selection transistors are changed due to various factors, the cell string may not be controlled as intended. This may mean that the reliability and performance of the memory device 100 is reduced.

Below, for convenience of description, the description will be given as the ground selection transistor GST has the 0-th erase state E0 or the 0-th program state P0, but the present disclosure is not limited thereto. For example, the ground selection transistor GST may have one of a plurality of threshold voltage states and may be turned on or turned off in response to a voltage level corresponding to the threshold voltage state. For example, a first ground selection transistor may have a first threshold voltage state, a second ground selection transistor may have a second threshold voltage state higher than the first threshold voltage state, and a third ground selection transistor may have a third threshold voltage state higher than the second threshold voltage state. In this case, the first ground selection transistor may be turned on by a first voltage higher than the first threshold voltage state and lower than the second and third threshold voltage states, and the second and third ground selection transistors may be turned off by the first voltage. The first and second ground selection transistors may be turned on by a second voltage higher than the first and second threshold voltage states and lower than the third threshold voltage state, and the third ground selection transistor may be turned off by the second voltage. The first, second, and third ground selection transistors may be turned on by a third voltage higher than the third threshold voltage state. As described above, each of the ground selection transistors may have one of the plurality of threshold voltage states and may be turned on or turned off in response to a voltage applied to the corresponding ground selection line.

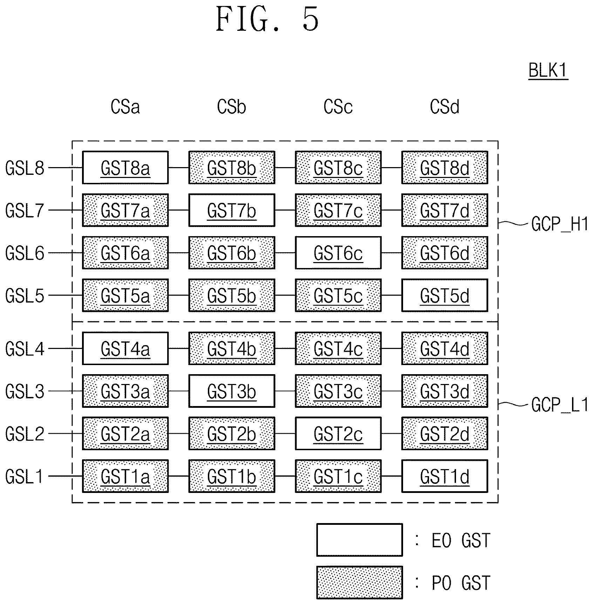

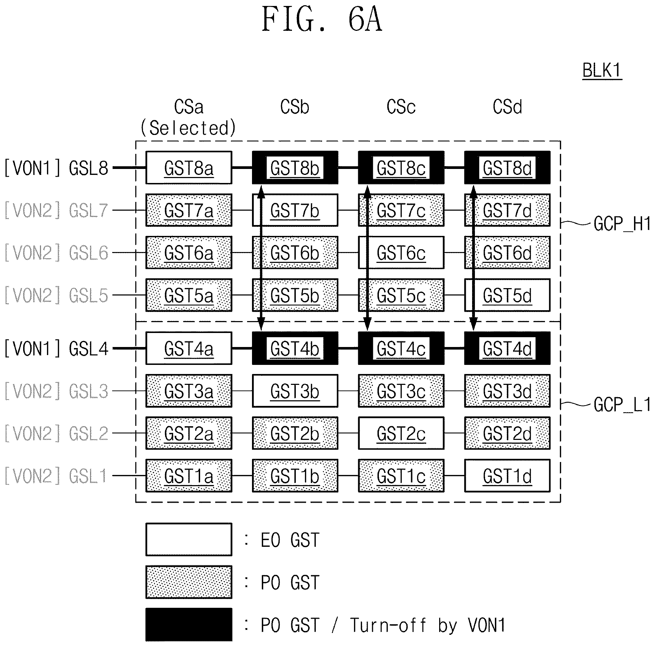

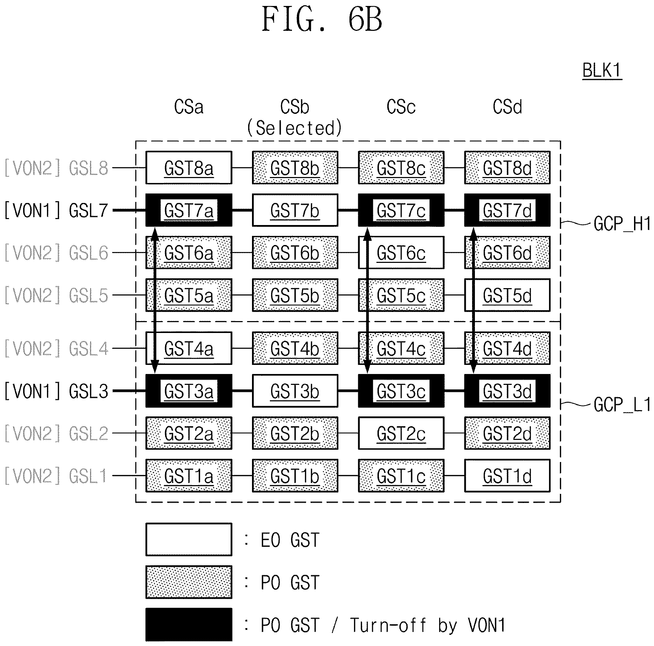

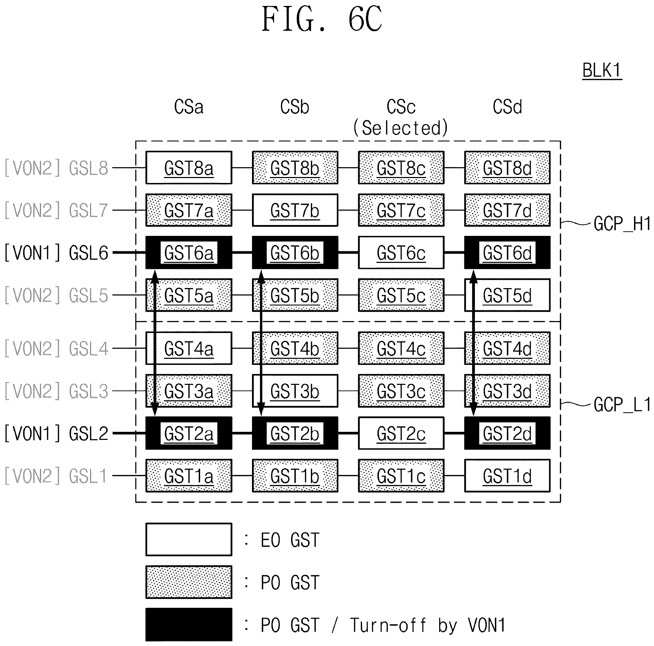

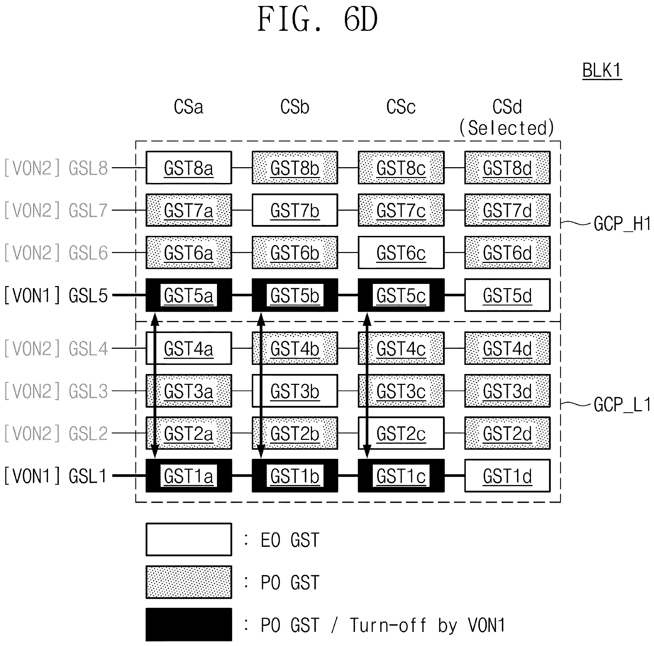

FIG. 5 is a diagrams illustrating an example of a ground selection transistor (GST) coding pattern (GCP) of ground selection transistors of a first memory block of FIG. 2. FIGS. 6A, 6B, 6C, and 6D are diagrams for describing an example of an operation of a memory block including ground selection transistors programmed depending on the GST coding pattern of FIG. 5.

Below, for brevity of drawing, a ground selection transistor coding pattern corresponding to ground selection transistors of the first memory block BLK1 is illustrated. However, the present disclosure is not limited thereto. For example, it may be understood that the ground selection transistors of the memory device 100 have threshold voltages corresponding to a ground selection transistor coding pattern to be described with reference to the following drawings, and the ground selection transistors is applicable to the first memory block BLK1 or the memory device 100 described above.

First, referring to FIGS. 1, 2, 5, 6A, 6B, 6C, and 6D, the first memory block BLK1 may include the a-th to d-th cell strings CSa to CSd. The a-th cell string CSa may include a plurality of ground selection transistors GST1a to GST8a, the b-th cell string CSb may include a plurality of ground selection transistors GST1b to GST8b, the c-th cell string CSc may include a plurality of ground selection transistors GST1c to GST8c, and the d-th cell string CSd may include a plurality of ground selection transistors GST1d to GST8d.

In some implementations, as described above, each of the plurality of cell strings CSa to CSd may further include at least one string selection transistor SST, a plurality of memory cells MC, at least one dummy memory cell DMC, and at least one erase control transistor ECT.

The ground selection transistors GST1a, GST1b, GST1c, and GST1d of the a-th to d-th cell strings CSa to CSd may be connected to the first ground selection line GSL1; the ground selection transistors GST2a, GST2b, GST2c, and GST2d of the a-th to d-th cell strings CSa to CSd may be connected to the second ground selection line GSL2; the ground selection transistors GST3a, GST3b, GST3c, and GST3d of the a-th to d-th cell strings CSa to CSd may be connected to the third ground selection line GSL3; and, the ground selection transistors GST4a, GST4b, GST4c, and GST4d of the a-th to d-th cell strings CSa to CSd may be connected to the fourth ground selection line GSL4.

The ground selection transistors GST5a, GST5b, GST5c, and GST5d of the a-th to d-th cell strings CSa to CSd may be connected to a fifth ground selection line GSL5; the ground selection transistors GST6a, GST6b, GST6c, and GST6d of the a-th to d-th cell strings CSa to CSd may be connected to a sixth ground selection line GSL6; the ground selection transistors GST7a, GST7b, GST7c, and GST7d of the a-th to d-th cell strings CSa to CSd may be connected to a seventh ground selection line GSL7; and, the ground selection transistors GST8a, GST8b, GST8c, and GST8d of the a-th to d-th cell strings CSa to CSd may be connected to an eighth ground selection line GSL8.

The ground selection transistors GST1a to GST4d connected to the first to fourth ground selection lines GSL1 to GSL4 may be programmed based on a first lower GST coding pattern GCP_L1. The ground selection transistors GST5a to GST8d connected to the fifth to eighth ground selection lines GSL5 to GSL8 may be programmed based on a first upper GST coding pattern GCP_H1.

In some implementations, the first to fourth ground selection lines GSL1 to GSL4 corresponding to the first lower GST coding pattern GCP_L1 may be lower ground selection lines, and the fifth to eighth ground selection lines GSL5 to GSL8 corresponding to the first upper GST coding pattern GCP_H1 may be upper ground selection lines. In some implementations, the lower ground selection lines GSL1 to GSL4 may be stacked on the substrate, and the upper ground selection lines GSL5 to GSL8 may be stacked on the lower ground selection lines GSL1 to GSL4.

For example, each of the first lower GST coding pattern GCP_L1 and the first upper GST coding pattern GCP_H1 may be information indicating a threshold voltage state (e.g., P0 or E0) of the ground selection transistors.

In some implementations, the first lower GST coding pattern GCP_L1 may be identical to the first upper GST coding pattern GCP_H1. For example, when the ground selection transistors GST1a to GST4d are programmed based on the first lower GST coding pattern GCP_L1, the 4a-th, 3b-th, 2c-th, and 1d-th ground selection transistors GST4a, GST3b, GST2c, and GST1d may have the 0-th erase state E0, and the remaining ground selection transistors GST1a, GST1b, GST1c, GST2a, GST2b, GST2d, GST3a, GST3c, GST3d, GST4b, GST4c, and GST4d may have the 0-th program state P0. When the ground selection transistors GST5a to GST8d are programmed based on the first upper GST coding pattern GCP_H1, the 8a-th, 7b-th, 6c-th, and 5d-th ground selection transistors GST8a, GST7b, GST6c, and GST5d may have the 0-th erase state E0, and the remaining ground selection transistors GST5a, GST5b, GST5c, GST6a, GST6b, GST6d, GST7a, GST7c, GST7d, GST8b, GST8c, and GST8d may have the 0-th program state P0.

When the ground selection transistors GST1a to GST8d are programmed as illustrated in FIG. 5, the reduction of performance or reliability due to the change in threshold voltages of the ground selection transistors may be decreased or prevented.

For example, as illustrated in FIG. 6A, it is assumed that the a-th cell string CSa is a selected cell string. In this case, according to the first lower GST coding pattern GCP_L1 and the first upper GST coding pattern GCP_H1, because the 4a-th and 8a-th ground selection transistors GST4a and GST8a of the a-th cell string CSa are in the 0-th erase state E0 and the remaining ground selection transistors GST1a, GST2a, GST3a, GST5a, GST6a, and GST7a are in the 0-th program state P0, the first on-voltage VON1 may be applied to the fourth and eighth ground selection lines GSL4 and GSL8, and the second on-voltage VON2 may be applied to the remaining ground selection lines GSL1, GSL2, GSL3, GSL5, GSL6, and GSL7.

According to the bias of the ground selection lines GSL1 to GSL8 of FIG. 6A, the ground selection transistors GST1a to GST8a of the a-th cell string CSa may be turned on. The 4b-th and 8b-th ground selection transistors GST4b and GST8b of the b-th cell string CSb, the 4c-th and 8c-th ground selection transistors GST4c and GST8c of the c-th cell string CSc, and the 4d-th and 8d-th ground selection transistors GST4d and GST8d of the d-th cell string CSd may be turned off by the first on-voltage VON1 of the fourth and eighth ground selection lines GSL4 and GSL8.

As illustrated in FIG. 6A, when the a-th cell string CSa is a selected cell string, in the b-th, c-th, and d-th cell strings CSb, CSc, and CSd, the turned-off ground selection transistors may be physically spaced apart from each other. For example, the 4b-th and 8b-th ground selection transistors GST4b and GST8b of the b-th cell string CSb, which are turned off, may be physically spaced apart from each other. The 4c-th and 8c-th ground selection transistors GST4c and GST8c of the c-th cell string CSc, which are turned off, may be physically spaced apart from each other. The 4d-th and 8d-th ground selection transistors GST4d and GST8d of the d-th cell string CSd, which are turned off, may be physically spaced apart from each other.

In some implementations, that specific ground selection transistors are physically spaced apart from each other may mean that the specific ground selection transistors are spaced apart from each other as much as a physical distance or may mean that at least one ground selection transistor is present between the specific ground selection transistors.

In some implementations, in the b-th, c-th, and d-th cell strings CSb, CSc, and CSd being an unselected cell string, ground selection transistors present between the ground selection transistors turned off and spaced apart from each other may be in a turn-on state. For example, in the b-th cell string CSb being an unselected cell string, the 5b-th, 6b-th, and 7th-ground selection transistors GST5b, GST6b, and GST7b present between the 4b-th and 8b-th ground selection transistors GST4b and GST8b turned off may be in a turn-on state. Configurations of ground selection transistors of the remaining cell strings CSc and CSd are similar to the above configuration, and thus, additional description will be omitted to avoid redundancy.

Next, as illustrated in FIG. 6B, it is assumed that the b-th cell string CSb is a selected cell string. In this case, according to the first lower GST coding pattern GCP_L1 and the first upper GST coding pattern GCP_H1, because the 3b-th and 7b-th ground selection transistors GST3b and GST7b of the b-th cell string CSb are in the 0-th erase state E0 and the remaining ground selection transistors GST1b, GST2b, GST4b, GST5b, GST6b, and GST8b are in the 0-th program state P0, the first on-voltage VON1 may be applied to the third and seventh ground selection lines GSL3 and GSL7, and the second on-voltage VON2 may be applied to the remaining ground selection lines GSL1, GSL2, GSL4, GSL5, GSL6, and GLS8.

According to the bias of the ground selection lines GSL1 to GSL8 of FIG. 6B, all the ground selection transistors GST1b to GST8b of the b-th cell string CSb may be turned on. The 3a-th and 7a-th ground selection transistors GST3a and GST7a of the a-th cell string CSa, the 3c-th and 7c-th ground selection transistors GST3c and GST7c of the c-th cell string CSc, and the 3d-th and 7d-th ground selection transistors GST3d and GST7d of the d-th cell string CSd may be turned off by the first on-voltage VON1 of the third and seventh ground selection lines GSL3 and GSL7.

When the b-th cell string CSb is a selected cell string, in each of the a-th, c-th, and d-th cell strings CSa, CSc, and CSd, the turned-off ground selection transistors may be physically spaced apart from each other. For example, in the a-th cell string CSa, the 3a-th and 7a-th ground selection transistors GST3a and GST7a turned off may be physically spaced apart from each other. In the c-th cell string CSc, the 3c-th and 7c-th ground selection transistors GST3c and GST7c turned off may be physically spaced apart from each other. In the d-th cell string CSd, the 3d-th and 7d-th ground selection transistors GST3d and GST7d turned off may be physically spaced apart from each other.

Next, as illustrated in FIG. 6C, it is assumed that the c-th cell string CSc is a selected cell string. In this case, according to the first lower GST coding pattern GCP_L1 and the first upper GST coding pattern GCP_H1, because the 2c-th and 6c-th ground selection transistors GST2c and GST6c of the c-th cell string CSc are in the 0-th erase state E0 and the remaining ground selection transistors GST1c, GST3c, GST4c, GST5c, GST7c, and GST8c are in the 0-th program state P0, the first on-voltage VON1 may be applied to the second and sixth ground selection lines GSL2 and GSL6, and the second on-voltage VON2 may be applied to the remaining ground selection lines GSL1, GSL3, GSL4, GSL5, GSL7, and GLS8.

According to the bias of the ground selection lines GSL1 to GSL8 of FIG. 6C, all the ground selection transistors GST1c to GST8c of the c-th cell string CSc may be turned on. The 2a-th and 6a-th ground selection transistors GST2a and GST6a of the a-th cell string CSa, the 2b-th and 6b-th ground selection transistors GST2b and GST6b of the b-th cell string CSb, and the 2d-th and 6d-th ground selection transistors GST2d and GST6d of the d-th cell string CSd may be turned off by the first on-voltage VON1 of the second and sixth ground selection lines GSL2 and GSL6.

When the c-th cell string CSc is a selected cell string, in each of the a-th, b-th, and d-th cell strings CSa, CSb, and CSd, the turned-off ground selection transistors may be physically spaced apart from each other. For example, in the a-th cell string CSa, the 2a-th and 6a-th ground selection transistors GST2a and GST6a turned off may be physically spaced apart from each other. In the b-th cell string CSb, the 2b-th and 6b-th ground selection transistors GST2b and GST6b turned off may be physically spaced apart from each other. In the d-th cell string CSd, the 2d-th and 6d-th ground selection transistors GST2d and GST6d turned off may be physically spaced apart from each other.

Then, as illustrated in FIG. 6D, it is assumed that the d-th cell string CSd is a selected cell string. In this case, according to the first lower GST coding pattern GCP_L1 and the first upper GST coding pattern GCP_H1, because the 1d-th and 5d-th ground selection transistors GST1d and GST5d of the d-th cell string CSd are in the 0-th erase state E0 and the remaining ground selection transistors GST2d, GST3d, GST4d, GST6d, GST7d, and GST8d are in the 0-th program state P0, the first on-voltage VON1 may be applied to the first and fifth ground selection lines GSL1 and GSL5, and the second on-voltage VON2 may be applied to the remaining ground selection lines GSL2, GSL3, GSL4, GSL6, GSL7, and GLS8.

According to the bias of the ground selection lines GSL1 to GSL8 of FIG. 6D, all the ground selection transistors GST1d to GST8d of the d-th cell string CSd may be turned on. The 1a-th and 5a-th ground selection transistors GST1a and GST5a of the a-th cell string CSa, the 2b-th and 5b-th ground selection transistors GST2b and GST5b of the b-th cell string CSb, and the 2d-th and 5d-th ground selection transistors GST2d and GST5d of the d-th cell string CSd may be turned off by the first on-voltage VON1 of the first and fifth ground selection lines GSL1 and GSL5.

When the d-th cell string CSd is a selected cell string, in each of the a-th, b-th, and c-th cell strings CSa, CSb, and CSc, the turned-off ground selection transistors may be physically spaced apart from each other. For example, in the a-th cell string CSa, the 1a-th and 5a-th ground selection transistors GST1a and GST5a turned off may be physically spaced apart from each other. In the b-th cell string CSb, the 1b-th and 5b-th ground selection transistors GST1b and GST5b turned off may be physically spaced apart from each other. In the c-th cell string CSc, the 1c-th and 5c-th ground selection transistors GST1c and GST5c turned off may be physically spaced apart from each other.

In some implementations, as described with reference to FIGS. 5 to 6D, the ground selection transistors GST1a to GST8d may be programmed based on the first lower GST coding pattern GCP_L1 and the first upper GST coding pattern GCP_H1. In this case, to select a specific cell string (i.e., to electrically connect the specific cell string to the common source line CSL and disconnect the remaining cell strings from the common source line CSL), the first on-voltage VON1 may be applied to at least one of lower ground selection lines, the first on-voltage VON1 may be applied to at least one of upper ground selection lines, and the second on-voltage VON2 may be applied to the remaining ground selection lines. In this case, the lower ground selection lines may indicate the ground selection lines GSL1 to GSL4 connected to the ground selection transistors GST1a to GST4d programmed depending on the first lower GST coding pattern GCP_L1, and the upper ground selection lines may indicate the ground selection lines GSL5 to GSL8 connected to the ground selection transistors GST5a to GST8d programmed depending on the first upper GST coding pattern GCP_H1.

As described above, when the ground selection transistors GST1a to GST8d are programmed depending on the first lower GST coding pattern GCP_L1 and the first upper GST coding pattern GCP_H1, in all unselected cell strings, ground selection transistors turned off by the first on-voltage VON1 may be physically spaced apart from each other. In this case, as the turned-off ground selection transistors (i.e., the ground selection transistors of the 0-th program state P0) are physically spaced apart from each other, the probability that all the ground selection transistors spaced apart from each other are turned on due to the change in threshold voltages of ground selection transistors may decrease. For example, in the implementation described with reference to FIG. 4A, in each cell string, one ground selection transistor is turned off. In this case, when the threshold voltage of the one ground selection transistor changes, an unselected cell string is electrically connected to a common source line. In contrast, as described with reference to FIGS. 5 to 6D, in an unselected cell string, because at least two ground selection transistors physically spaced apart from each other, even though the threshold voltage of one ground selection transistor among the at least two ground selection transistors changes, the unselected cell string is not electrically connected to the common source line CSL by the remaining ground selection transistor(s). This may mean that the reliability and performance of the memory device 100 are improved.

In some implementations, the GST coding patterns for ground selection transistors may be set in the process of manufacturing the memory device 100. Alternatively, while the memory device 100 operates, the memory device 100 may perform the program operation on ground selection transistors based on the GST coding pattern.

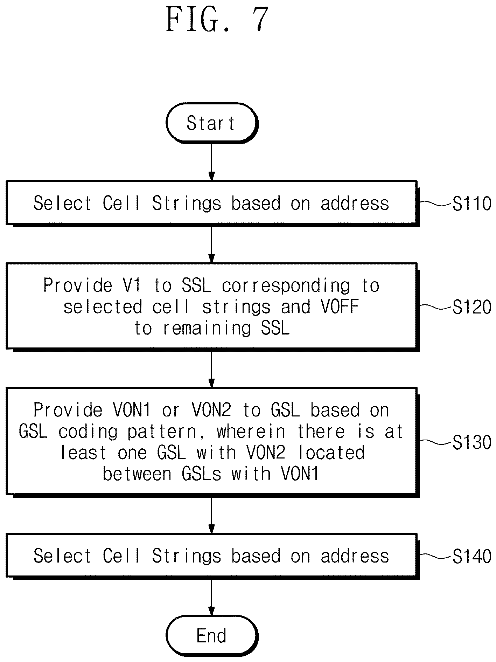

FIG. 7 is a flowchart illustrating an example of an operation of a memory device of FIG. 1. For convenience of description, components which are unnecessary to describe an implementation of the present disclosure will be omitted. In some implementations, it is assumed that the memory device 100 performs an operation on the first memory block BLK1 based on the flowchart of FIG. 7. In this case, the ground selection transistors of the first memory block BLK1 may have the GST coding pattern described with reference to FIGS. 5 to 6D.

In operation S110, the memory device 100 may select cell strings based on the address ADDR. For example, the memory device 100 may receive the command CMD and the address ADDR from an external device (e.g., a controller). The memory device 100 may select cell strings corresponding to the address ADDR.

In operation S120, the memory device 100 may apply the first voltage V1 to the string selection line SSL corresponding to the selected cell strings. For example, the first voltage V1 may be a high voltage enough to turn on a string selection transistor of a selected cell string. The off voltage VOFF may be a low voltage enough to turn off string selection transistors of unselected cell strings.

In operation S130, the memory device 100 may apply the first on-voltage VON1 or the second on-voltage VON2 to the plurality of ground selection lines GSL1 to GSL8 based on the GST coding pattern. In this case, at least one ground selection line to which the second on-voltage VON2 is applied may be present between ground selection lines to which the first on-voltage VON1 is applied. For example, as described with reference to FIG. 6A, when the a-th cell string CSa is a selected cell string, the first on-voltage VON1 may be applied to the fourth and eighth ground selection lines GSL4 and GSL8, and the second on-voltage VON2 may be applied to the remaining ground selection lines GSL1, GSL2, GSL3, GSL5, GSL6, and GSL7. In this case, at least one ground selection line (e.g., GSL5, GSL6, and GLS7) to which the second on-voltage VON2 is applied may be present between the fourth and eighth ground selection lines GSL4 and GSL8 to which the first on-voltage VON1 is applied.

In operation S140, the memory device 100 may control a word line based on a command and an address. For example, the memory device 100 may select a word line based on the received address. The memory device 100 may control a voltage of the selected word line based on the command (or may apply the read voltage or the program voltage to the selected word line based on the command).

In FIG. 7, to describe implementations of the present disclosure easily, operation S110 to operation S140 are described individually, but the present disclosure is not limited thereto. For example, the memory device 100 may perform operation S110 to operation S140 in parallel or at the same time.

As described above, a memory block (e.g., BLK1) of the memory device 100 may include a plurality of cell strings. The plurality of cell strings may include a plurality of ground selection transistors, and the plurality of ground selection transistors may be programmed based on the GST coding pattern.

In this case, the GST coding pattern may be set to satisfy a specific condition.

For example, the GST coding pattern may be set such that turned-off ground selection transistors of an unselected cell string are physically spaced apart from each other. In this case, at least one ground selection transistor present between the turned-off ground selection transistors of the unselected cell string may be in a turn-on state.

Alternatively, at least ground selection line to which the second on-voltage VON2 is applied may be present between ground selection lines to which the first on-voltage VON1 is applied.

Alternatively, some of the ground selection transistors (e.g., ground selection transistors adjacent to the substrate) may be programmed based on a lower GST coding pattern, and the others of the ground selection transistors may be programmed based on an upper GST coding pattern. In this case, to select one of a plurality of cell strings, the first on-voltage VON1 may be applied to at least one of lower ground selection lines, the first on-voltage VON1 may be applied to at least one of upper ground selection lines, and the second on-voltage VON2 may be applied to the remaining ground selection lines. According to the above bias condition, the lower ground selection lines may be connected to ground selection transistors programmed based on the lower GST coding pattern, and the upper ground selection lines may be connected to ground selection transistors programmed based on the upper GST coding pattern.

The above GST coding pattern may allow a selected cell string to be electrically connected to the common source line CSL and an unselected cell string to be electrically disconnected from the common source line CSL. Also, even though threshold voltages of some ground selection transistors change, the above operation may be normally performed. Accordingly, the reliability and performance of the memory device 100 may be improved.

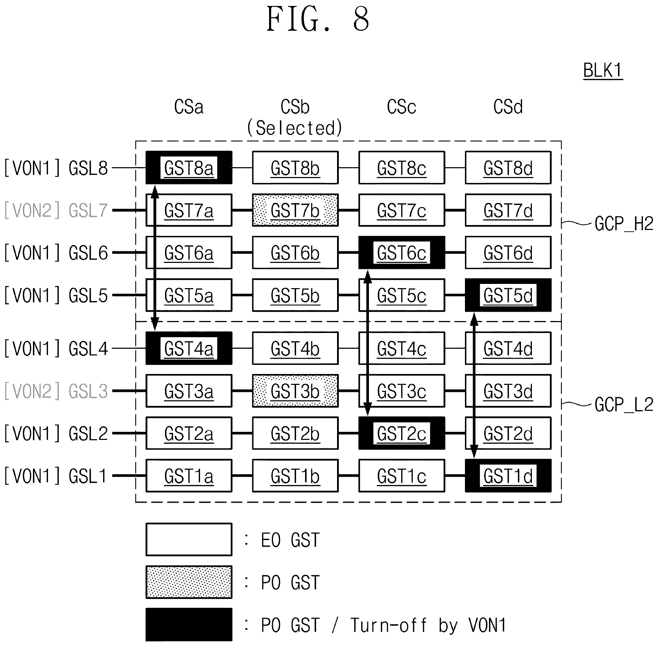

FIGS. 8, 9, 10, 11, 12, 13, 14, and 15 are diagrams for describing an example of a GST coding pattern for ground selection transistors of a memory block of FIG. 2. Various types of GST coding patterns according to implementations of the present disclosure will be described with reference to the following drawings. For brevity of drawing and for convenience of description, components which are unnecessary to describe the GST coding pattern are omitted. However, the present disclosure is not limited thereto. For example, the GST coding patterns to be described with reference to the following drawings may be applied to ground selection transistors of each of a plurality of memory blocks.

Below, for brevity of drawing and for convenience of description, it is assumed that the b-th cell string CSb is a selected cell string. However, the present disclosure is not limited thereto. For example, any other cell string may be selected, and in this case, voltages of ground selection lines may be controlled depending on the GST coding pattern.

First, referring to FIGS. 1, 2, and 8, the first memory block BLK1 may include the a-th to d-th cell strings CSa, CSb, CSc, and CSd. The a-th cell string CSa may include the 1a-th to 8a-th ground selection transistors GST1a to GST8a, the b-th cell string CSb may include the 1b-th to 8b-th ground selection transistors GST1b to GST8b, the c-th cell string CSc may include the 1c-th to 8c-th ground selection transistors GST1c to GST8c, and the d-th cell string CSd may include the 1d-th to 8d-th ground selection transistors GST1d to GST8d.

The plurality of ground selection transistors GST1a to GST8d may be programmed based on a second lower GST coding pattern GCP_L2 and a second upper GST coding pattern GCP_H2. For example, the ground selection transistors GST1a to GST4d may be programmed based on the second lower GST coding pattern GCP_L2. For example, the 4a-th, 3b-th, 2c-th, and 1d-th ground selection transistors GST4a, GST3b, GST2c, and GST1d may have the 0-th program state P0, and the remaining ground selection transistors GST1a, GST1b, GST1c, GST2a, GST2b, GST2d, GST3a, GST3c, GST3d, GST4b, GST4c, and GST4d may have the 0-th erase state E0.

The ground selection transistors GST5a to GST8d may be programmed based on the second upper GST coding pattern GCP_H2. In this case, the 8a-th, 7b-th, 6c-th, and 5d-th ground selection transistors GST8a, GST7b, GST6c, and GST5d may have the 0-th program state P0, and the remaining ground selection transistors GST5a, GST5b, GST5c, GST6a, GST6b, GST6d, GST7a, GST7c, GST7d, GST8b, GST8c, and GST8d may have the 0-th erase state E0.

In some implementations, it is assumed that the b-th cell string CSb is a selected cell string. In this case, the 1b-th, 2b-th, 4b-th, 5b-th, 6b-th, and 8b-th ground selection transistors GST1b, GST2b, GST4b, GST5b, GST7b, and GST8b of the b-th cell string CSb have the 0-th erase state E0 and the 3b-th and 7b-th ground selection transistors GST3b and GST7b of the b-th cell string CSb have the 0-th program state P0, the first on-voltage VON1 may be applied to the first, second fourth, fifth, sixth, and eighth ground selection lines GSL1, GSL2, GSL4, GSL5, GLS6, and GSL8, and the second on-voltage VON2 may be applied to the third and seventh ground selection lines GSL3 and GSL7.

According to the bias of the ground selection lines GSL1 to GSL8 of FIG. 8, all the ground selection transistors GST1b to GST8b of the b-th cell string CSb being a selected cell string may be turned on. In the a-th cell string CSa being an unselected cell string, the 4a-th and 8a-th ground selection transistors GST4a and GST8a may be respectively turned off by the first on-voltages VON1 of the fourth and eighth ground selection lines GSL4 and GSL8. In the c-th cell string CSc being an unselected cell string, the 2c-th and 6c-th ground selection transistors GST2c and GST6c may be respectively turned off by the first on-voltages VON1 of the second and sixth ground selection lines GSL2 and GSL6. In the d-th cell string CSd being an unselected cell string, the 1d-th and 5d-th ground selection transistors GST1d and GST5d may be respectively turned off by the first on-voltages VON1 of the first and fifth ground selection lines GSL1 and GSL5.

That is, in the implementation of FIG. 8, when the b-th cell string CSb is a selected cell string, in the remaining cell strings CSa, CSc, and CSd, turned-off ground selection transistors may be physically spaced apart from each other. In some implementations, even though any other cell string is selected, turned-off ground selection transistors of an unselected cell string may be physically spaced apart from each other.

In the implementations of FIGS. 5 to 8, the lower GST coding pattern and the upper GST coding pattern are identical to each other. However, the present disclosure is not limited thereto. For example, the lower GST coding pattern and the upper GST coding pattern may be set to be different from each other.

For example, referring to FIGS. 1, 2, and 9, the first memory block BLK1 may include the a-th to d-th cell strings CSa, CSb, CSc, and CSd, and the a-th to d-th cell strings CSa, CSb, CSc, and CSd may include the plurality of ground selection transistors GST1a to GST8d.

The plurality of ground selection transistors GST1a to GST8d may be programmed based on a third lower GST coding pattern GCP_L3 and a third upper GST coding pattern GCP_H3. For example, the ground selection transistors GST1a to GST4d may be programmed based on the third lower GST coding pattern GCP_L3. In this case, the 3a-th, 4b-th, 1c-th, and 2d-th ground selection transistors GST3a, GST4b, GST1c, and GST2d may have the 0-th erase state E0, and the remaining ground selection transistors GST1a, GST1b, GST1d, GST2a, GST2b, GST2c, GST3b, GST3c, GST3d, GST4a, GST4c, and GST4d may have the 0-th program state P0.

The ground selection transistors GST5a to GST8d may be programmed based on the third upper GST coding pattern GCP_H3. The third upper GST coding pattern GCP_H3 is similar to the first upper GST coding pattern GCP_H1 of FIG. 5, and thus, additional description will be omitted to avoid redundancy.

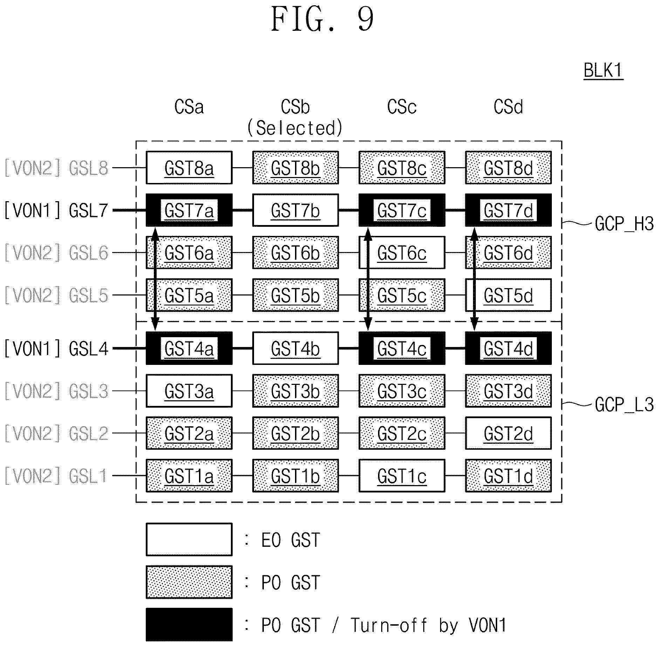

As illustrated in FIG. 9, even though the third upper GST coding pattern GCP_H3 and the third lower GST coding pattern GCP_L3 are different from each other, the third upper GST coding pattern GCP_H3 and the third lower GST coding pattern GCP_L3 may satisfy the above condition of the GST coding pattern. For example, it is assumed that the b-th cell string CSb is a selected cell string. In this case, because the 4b-th and 7b-th ground selection transistors GST4b and GST7b of the b-th cell string CSb have the 0-th erase state E0 and the 1b-th, 2b-th, 3b-th, 5b-th, 6b-th, and 8b-th ground selection transistors GST1b, GST2b, GST3b, GST5b, GST6b, and GST8b of the b-th cell string CSb have the 0-th program state P0, the first on-voltage VON1 may be applied to the fourth and seventh ground selection lines GSL4 and GSL7, and the second on-voltage VON2 may be applied to the first, second, third, fifth, sixth, and eighth ground selection lines GSL1, GSL2, GSL3, GSL5, GSL6, and GLS8.

According to the bias of the ground selection lines GSL1 to GSL8 of FIG. 9, all the ground selection transistors GST1b to GST8b of the b-th cell string CSb being a selected cell string may be turned on. In the a-th, c-th, and d-th cell strings CSa, CSc, and CSd being an unselected cell string, the 4a-th and 7a-th ground selection transistors GST4a and GST7a, the 4c-th and 7c-th ground selection transistors GST4c and GST7c, and the 4d-th and 7d-th ground selection transistors GST4d and GST7d may be respectively turned off by the first on-voltages VON1 of the fourth and seventh ground selection lines GSL4 and GSL7.

In this case, as illustrated in FIG. 9, in the unselected cell strings CSa, CSc, and CSd, the turned-off ground selection transistors may be physically spaced apart from each other. Although not illustrated in a drawing, even when any other cell string is selected, turned-off ground selection transistors of unselected cell strings may be physically spaced apart from each other.

For example, referring to FIGS. 1, 2, and 10, the first memory block BLK1 may include the a-th to d-th cell strings CSa, CSb, CSc, and CSd, and the a-th to d-th cell strings CSa, CSb, CSc, and CSd may include the plurality of ground selection transistors GST1a to GST8d.

The plurality of ground selection transistors GST1a to GST8d may be programmed based on a fourth lower GST coding pattern GCP_L4 and a fourth upper GST coding pattern GCP_H4. For example, the ground selection transistors GST1a to GST4d may be programmed based on the fourth lower GST coding pattern GCP_L4. For example, the 1a-th, 2b-th, 3c-th, and 4d-th ground selection transistors GST1a, GST2b, GST3c, and GST4d may have the 0-th program state P0, and the remaining ground selection transistors GST1b, GST1c, GST1d, GST2a, GST2c, GST2d, GST3a, GST3b, GST3d, GST4a, GST4b, and GST4c may have the 0-th erase state E0.

The ground selection transistors GST5a to GST8d may be programmed based on the fourth upper GST coding pattern GCP_H4. The fourth upper GST coding pattern GCP_H4 is similar to the first upper GST coding pattern GCP_H1 of FIG. 5, and thus, additional description will be omitted to avoid redundancy.

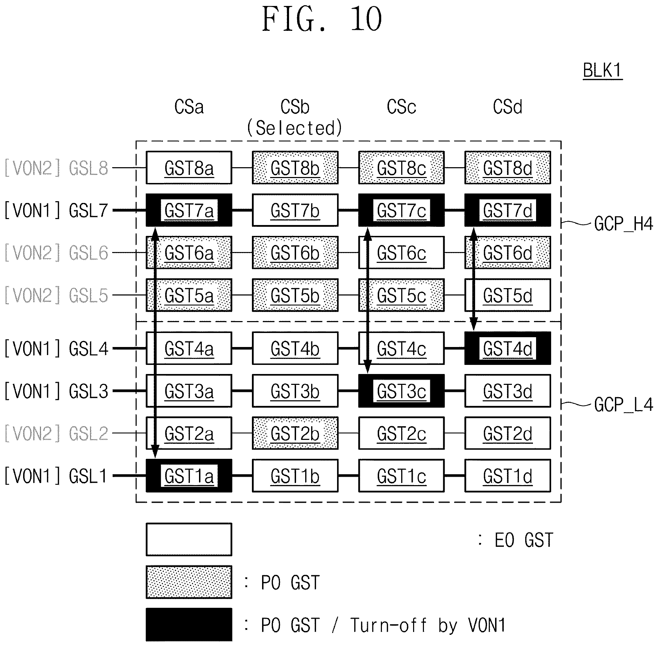

As illustrated in FIG. 10, the fourth upper GST coding pattern GCP_H4 and the fourth lower GST coding pattern GCP_L4 may be different from each other. For example, in the implementation of FIG. 5, each of the first upper GST coding pattern GCP_HT1 and the first lower GST coding pattern GCP_L1 may be a 1-erase pattern; in the implementation of FIG. 8, each of the second upper GST coding pattern GCP_H2 and the second lower GST coding pattern GCP_L2 may be a 1-program pattern. The 1-erase pattern may refer to a pattern in which one of ground selection transistors of each cell string has the 0-th erase state E0 and the others thereof have the 0-th program state P0. The 1- program pattern may refer to a pattern in which one of ground selection transistors of each cell string has the 0-th program state P0 and the others thereof have the 0-th erase state E0.

In the implementation of FIG. 10, the fourth upper GST coding pattern GCP_H4 may be the 1-erase pattern, and the fourth lower GST coding pattern GCP_L4 may be the 1-program pattern. Nevertheless, according to the implementation of FIG. 10, the above condition of the GST coding pattern may be satisfied.

For example, as illustrated in FIG. 10, it is assumed that the b-th cell string CSb is a selected cell string. In this case, because the 1b-th, 3b-th, 4b-th, and 7b-th ground selection transistors GST1b, GST3b, GST4b, and GST7b of the b-th cell string CSb are in the 0-th erase state E0 and the remaining ground selection transistors GST2b, GST5b, GST6b, and GST8b are in the 0-th program state P0, the first on-voltage VON1 may be applied to the first, third, fourth, and seventh ground selection lines GSL1, GSL3, GSL4, and GSL7, and the second on-voltage VON2 may be applied to the remaining ground selection lines GSL2, GSL5, GSL6, and GLS8.

According to the bias of the ground selection lines GSL1 to GSL8 of FIG. 10, all the ground selection transistors GST1b to GST8b of the b-th cell string CSb being a selected cell string may be turned on. The 1a-th and 7a-th ground selection transistors GST1a and GST7a of the a-th cell string CSa being an unselected cell string may be turned off by the first on-voltages VON1 of the first and seventh ground selection lines GSL1 and GSL7. The 3c-th and 7c-th ground selection transistors GST3c and GST7c of the c-th cell string CSc being an unselected cell string may be turned off by the first on-voltages VON1 of the third and seventh ground selection lines GSL3 and GSL7. The 4d-th and 7d-th ground selection transistors GST4d and GST7d of the d-th cell string CSd being an unselected cell string may be turned off by the first on-voltages VON1 of the fourth and seventh ground selection lines GSL4 and GSL7.

In this case, as illustrated in FIG. 10, in the unselected cell strings CSa, CSc, and CSd, the turned-off ground selection transistors may be physically spaced apart from each other. Although not illustrated in a drawing, even when any other cell string is selected, turned-off ground selection transistors of unselected cell strings may be physically spaced apart from each other.

For example, referring to FIGS. 1, 2, and 11, the first memory block BLK1 may include the a-th to d-th cell strings CSa, CSb, CSc, and CSd, and the a-th to d-th cell strings CSa, CSb, CSc, and CSd may include a plurality of ground selection transistors GST1a to GST16d.

In some implementations, the ground selection transistors GST1a to GST16d may be programmed based on a fifth lower GST coding pattern GCP_L5 and a fifth upper GST coding pattern GCP_H5. Each of the fifth lower GST coding pattern GCP_L5 and the fifth upper GST coding pattern GCP_H5 may refer to a pattern in which at least two adjacent ground selection transistors have the same state.

For example, the ground selection transistors GST1a to GST8d connected to first to eighth ground selection lines GSL1 to GSL8 may be programmed based on the fifth lower GST coding pattern GCP_LS5. In this case, the 8a-th, 7a-th, 6b-th, 5b-th, 4c-th, 3c-th, 2d-th, and 1d-th ground selection transistors GST8a, GST7a, GST6b, GST5b, GST4c, GST3c, GST2d, and GST1d may have the 0-th erase state E0, and the remaining ground selection transistors GST6a, GST5a, GST4a, GST3a, GST2a, GST1a, GST8b, GST7b, GST4b, GST3b, GST2b, GST1b, GST8c, GST7c, GST6c, GST5c, GST2c, GST1c, GST8d, GST7d, GST6d, GST5d, GST4d, and GST3d may have the 0-th program state P0.

The ground selection transistors GST9a to GST16d connected to ninth to sixteenth ground selection lines GSL9 to GSL16 may be programmed based on the fifth upper GST coding pattern GCP_H5. In this case, the 16a-th, 15a-th, 14b-th, 13b-th, 12c-th, 11c-th, 10d-th, and 9d-th GST16a, GST15a, GST14b, GST13b, GST12c, GST11c, GST10d, and GST9d may have the 0-th erase state E0, and the remaining ground selection transistors GST14a, GST13a, GST12a, GST11a, GST10a, GST9a, GST16b, GST15b, GST12b, GST11b, GST10b, GST9b, GST16c, GST15c, GST14c, GST13c, GST10c, GST9c, GST16d, GST15d, GST14d, GST13d, GST12d, and GST11d may have the 0-th program state P0.

In some implementations, when the b-th cell string CSb is a selected cell string, the first on-voltage VON1 may be applied to the fifth, sixth, thirteenth, and fourteenth ground selection lines GSL5, GSL6, GSL13, and GSL14, and the second on-voltage VON2 may be applied to the remaining ground selection lines GSL1 to GSL4, GSL7 to GSL12, and GSL15 to GSL16. Accordingly, all the ground selection transistors GST1b to GST16b of the b-th cell string CSb may be turned on. Some ground selection transistors GST5a, GST6a, GST13a, GST14a, GST5c, GST6c, GST13c, GST14c, GST5d, GST6d, GST13d, and GST14d of the a-th, c-th, and d-th cell strings CSa, CSc, and CSd being an unselected cell string are turned off by the first on-voltages VON1 of the fifth, sixth, thirteenth, and fourteenth ground selection lines GSL5, GSL6, GSL13, and GSL14.

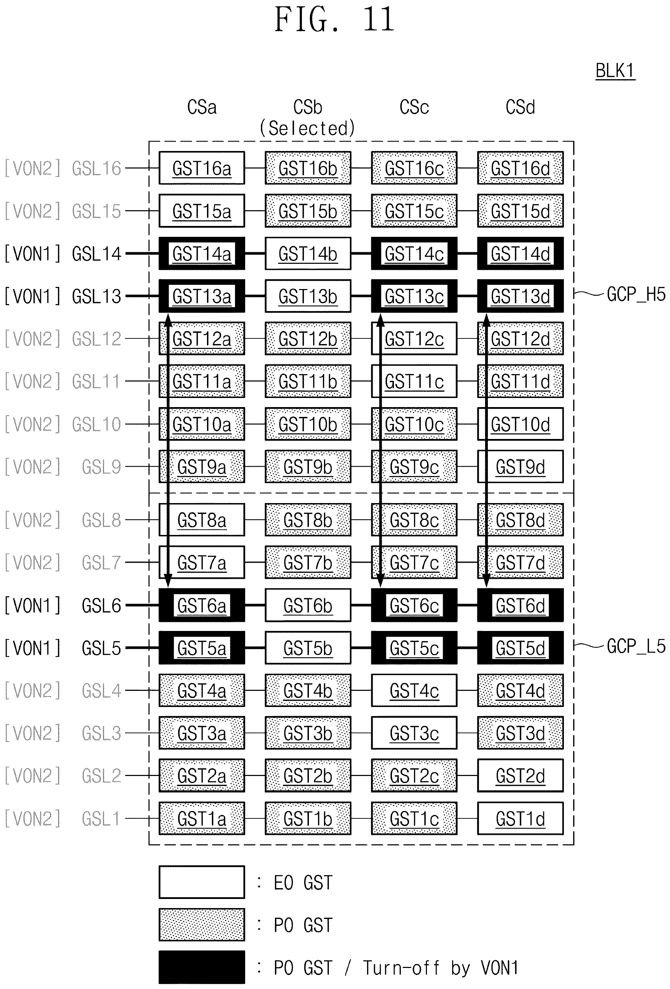

In this case, as illustrated in FIG. 11, in the unselected cell strings CSa, CSc, and CSd, the turned-off ground selection transistors may be physically spaced apart from each other. For example, in the a-th cell string CSa being an unselected cell string, the 5a-th and 6-th ground selection transistors GST5a and GST6a may be physically spaced apart from the 13a-th and 14a-th ground selection transistors GST13a and GST14a. In the c-th cell string CSc being an unselected cell string, the 5c-th and 6c-th ground selection transistors GST5c and GST6c may be physically spaced apart from the 13c-th and 14c-th ground selection transistors GST13c and GST14c. In the d-th cell string CSd being an unselected cell string, the 5d-th and 6d-th ground selection transistors GST5d and GST6d may be physically spaced apart from the 13d-th and 14d-th ground selection transistors GST13d and GST14d. Although not illustrated in a drawing, even when any other cell string is selected, turned-off ground selection transistors of unselected cell strings may be physically spaced apart from each other.

Next, referring to FIGS. 1, 2, and 12, the first memory block BLK1 may include the a-th to d-th cell strings CSa, CSb, CSc, and CSd, and the a-th to d-th cell strings CSa, CSb, CSc, and CSd may include the plurality of ground selection transistors GST1a to GST8d.

In some implementations, the plurality of ground selection transistors GST1a to GST8d may be programmed based on a sixth lower GST coding pattern GCP_L6 and a sixth upper GST coding pattern GCP_H6. The sixth lower GST coding pattern GCP_L6 and the sixth upper GST coding pattern GCP_H6 may be a pattern in which at least two ground selection transistors have the same state.

For example, the ground selection transistors GST1a to GST4d connected to the first to fourth ground selection lines GSL1 to GSL4 may be programmed based on a sixth lower GST coding pattern GCP_L6. In this case, the 4a-th, 3a-th, 3b-th, 2b-th, 2c-th, 1c-th, 1d-th, and 4d-th ground selection transistors GST4a, GST3a, GST3b, GST2b, GST2c, GST1c, GST1d, and GST4d may have the 0-th erase state E0, and the remaining ground selection transistors GST2a, GST1a, GST4b, GST1b, GST4c, GST3c, GST3d, and GST2d may have the 0-th program state P0.

The ground selection transistors GST5a to GST8d connected to the fifth to eighth ground selection lines GSL5 to GSL8 may be programmed based on the sixth upper GST coding pattern GCP_H6. In this case, the 8a-th, 7a-th, 7b-th, 6b-th, 6c-th, 5c-th, 5d-th, and 8d-th ground selection transistors GST8a, GST7a, GST7b, GST6b, GST6c, GST5c, GST5d, and GST8d may have the 0-th erase state E0, and the remaining ground selection transistors GST6a, GST5a, GST8b, GST5b, GST8c, GST7c, GST7d, and GST6d may have the 0-th program state P0.

In some implementations, when the b-th cell string CSb is a selected cell string, the first on-voltage VON1 may be applied to the second, third, sixth, and seventh ground selection lines GSL2, GSL3, GSL6, and GSL7, and the second on-voltage VON2 may be applied to the first, fourth, fifth, and eighth ground selection lines GSL1, GSL4, GSL5, and GSL8. In this case, all the ground selection transistors GST1b to GST8b of the b-th cell string CSb being a selected cell string may be turned on. The 2a-th and 6a-th ground selection transistors GST2a and GST6a of the a-th cell string CSa being an unselected cell string may be turned off by the first on-voltages VON1 of the second and sixth ground selection lines GSL2 and GSL6. The 3c-th and 7c-th ground selection transistors GST3c and GST7c of the c-th cell string CSc being an unselected cell string may be turned off by the first on-voltages VON1 of the third and seventh ground selection lines GSL3 and GSL7. The 2d-th, 3d-th, 6d-th, and 7d-th ground selection transistors GST2d, GST3d, GST6d and GST7d of the d-th cell string CSd being an unselected cell string may be turned off by the first on-voltages VON1 of the second, third, sixth, and seventh ground selection lines GSL2, GSL3, GSL6, and GSL7.

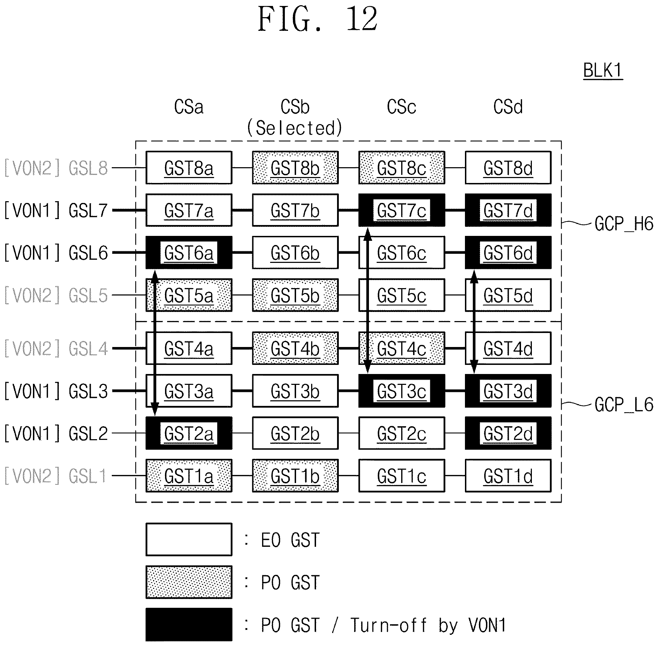

In this case, as illustrated in FIG. 12, in an unselected cell string, turned-off ground selection transistors may be physically spaced apart from each. Although not illustrated in a drawing, even though any other cell string is selected, turned-off ground selection transistors of an unselected cell string may be physically spaced apart from each other.

Next, referring to FIGS. 1, 2, and 13, the first memory block BLK1 may include the a-th to d-th cell strings CSa, CSb, CSc, and CSd. The a-th to d-th cell strings CSa to CSd may include a plurality of ground selection transistors GST1a to GST12d.

In the above implementation, a plurality of ground selection transistors are programmed based on two GST coding patterns (e.g., a lower GST coding pattern and an upper GST coding pattern). However, the present disclosure is not limited thereto. For example, a plurality of ground selection transistors may be programmed based on at least two GST coding patterns.

For example, the plurality of ground selection transistors GST1a to GST12d may be programmed based on a seventh lower GST coding pattern GCP_L7, a seventh intermediate GST coding pattern GCP_M7, and a seventh upper GST coding pattern GCP_H7. The ground selection transistors GST1a to GST4d connected to the first to fourth ground selection lines GSL1 to GSL4 may be programmed based on the seventh lower GST coding pattern GCP_L7. The ground selection transistors GST5a to GST8d connected to the fifth to eighth ground selection lines GSL5 to GSL8 may be programmed based on the seventh intermediate GST coding pattern GCP_M7. The ground selection transistors GST9a to GST12d connected to ninth to twelfth ground selection lines GSL9 to GSL12 may be programmed based on the seventh upper GST coding pattern GCP_H7.

Each of the seventh lower GST coding pattern GCP_L7, the seventh intermediate GST coding pattern GCP_M7, and the seventh upper GST coding pattern GCP_H7 is similar to the lower GST coding pattern GCP_L1 of FIG. 5, and thus, additional description will be omitted to avoid redundancy.

In some implementations, when the b-th cell string CSb is a selected cell string, the first on-voltage VON1 may be applied to the third, seventh, and eleventh ground selection lines GSL3, GSL7, and GSL11, and the second on-voltage VON2 may be applied to the remaining ground selection lines GLS1, GSL2, GSL4, GSL5, GSL6, GLS8, GSL9, GSL10, and GSL12. In this case, all the ground selection transistors GST1b to GST12b of the b-th cell string CSb being a selected cell string may be turned on. The 3a-th, 3c-th, 3d-th, 7a-th, 7c-th, 7d-th, 11a-th, 11c-th, and 11d-th ground selection transistors GST3a, GST3c, GST3d, GST7a, GST7c, GST7d, GST11a, GST11c, and GST11d of the a-th, c-th, and d-th cell strings CSa, CSc, and CSd being an unselected cell string may be respectively turned off by the first on-voltages VON1 of the third, seventh, and eleventh ground selection lines GSL3, GSL7, and GSL11.

In this case, in each of the unselected cell strings CSa, CSc, and CSd, the turned-off ground selection transistors may be physically spaced apart from each other.

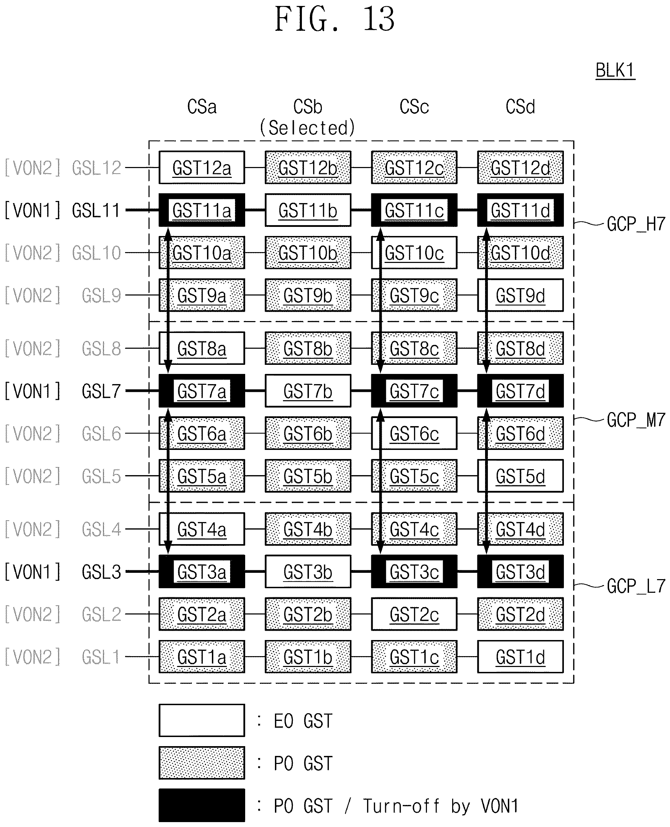

In the implementation of FIG. 13, the description is given as a plurality of ground selection transistors are programmed based on three GST coding patterns, but the present disclosure is not limited thereto. For example, a plurality of ground selection transistors may be programmed based on two or more GST coding patterns. The at least two or more GST coding patterns may have the same pattern. Alternatively, the at least two or more GST coding patterns may have different patterns.

Next, referring to FIGS. 1, 2, and 14, the first memory block BLK1 may include the a-th to d-th cell strings CSa, CSb, CSc, and CSd. The a-th to d-th cell strings CSa to CSd may include the plurality of ground selection transistors GST1a to GST8d and a plurality of dummy ground selection transistors dGSTa to dGSTd. The ground selection transistors GST1a to GST4d connected to the first to fourth ground selection lines GSL1 to GSL4 may be programmed based on an eighth lower GST coding pattern GCP_L8. The ground selection transistors GST5a to GST8d connected to the fifth to eighth ground selection lines GSL5 to GSL8 may be programmed based on an eighth upper GST coding pattern GCP_H8. Each of the eighth lower GST coding pattern GCP_L8 and the eighth upper GST coding pattern GCP_H8 is similar to the lower GST coding pattern GCP_L1 of FIG. 5, and thus, additional description will be omitted to avoid redundancy.

In some implementations, a dummy ground selection line dGSL may be located between the fourth and fifth ground selection lines GSL4 and GSL5. The dummy ground selection line dGSL may be connected to the plurality of dummy ground selection transistors dGSTa to dGSTd. That is, the dummy ground selection transistors dGSTa to dGSTd may be located between the ground selection transistors GST1a to GST4d programmed based on the eighth lower GST coding pattern GCP_L8 and the ground selection transistors GST5a to GST8d programmed based on the eighth upper GST coding pattern GCP_H8.

The dummy ground selection transistors dGSTa to dGSTd may have the 0-th program state P0. However, the present disclosure is not limited thereto. For example, the dummy ground selection transistors dGSTa to dGSTd may have a threshold voltage of the 0-th erase state E0 or any other threshold voltage.

In some implementations, the ground selection lines GSL1 to GSL8 or the ground selection transistors GST1a to GST8d connected to the ground selection lines GSL1 to GSL8 may be used to electrically connect a selected cell string among the plurality of cell strings CSa to CSd to a common source line. The dummy ground selection line dGSL or the dummy ground selection transistors dGSTa to dGSTd connected to the dummy ground selection line dGSL may be controlled regardless of controlling a selected cell string.

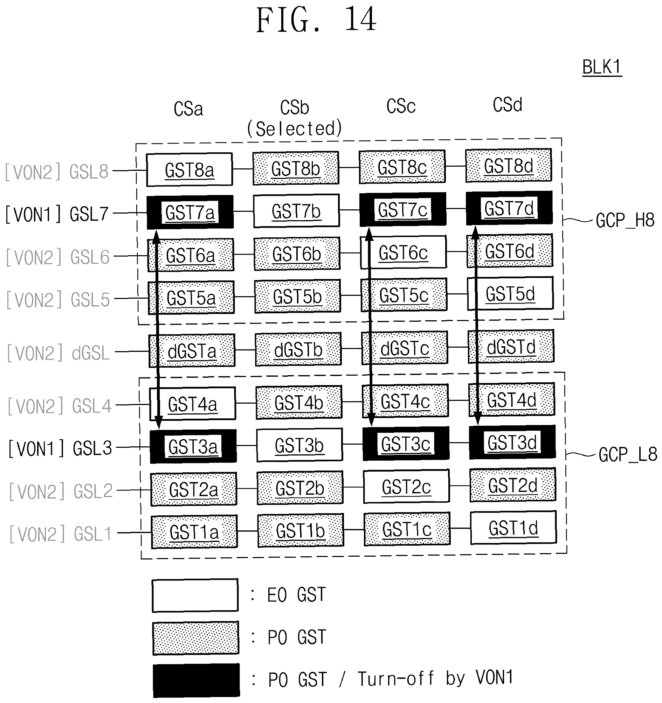

For example, in the implementation of FIG. 14, it is assumed that the b-th cell string CSb is a selected cell string. In this case, the first on-voltage VON1 may be applied to the third and seventh ground selection lines GSL3 and GSL7, and the second on-voltage VON2 may be applied to the remaining ground selection lines GSL1, GSL2, GSL4, GSL5, GSL6, GSL7, and GSL8. The second on-voltage VON2 may be applied to the dummy ground selection line dGSL.

According to the bias of the ground selection lines GSL1 to GSL8 and the dummy ground selection line dGSL of FIG. 14, all of the ground selection transistors GST1b to GST8b and the dummy ground selection transistor dGSTb of the b-th cell string CSb being a selected cell string may be turned on. The 3a-th, 3c-th, 3d-th, 7a-th, 7c-th, and 7d-th ground selection transistors GST3a, GST3c, GST3d, GST7a, GST7c, and GST7d of the a-th, c-th, and d-th cell strings CSa, CSc, and CSd being an unselected cell string may be turned off by the first on-voltages VON1 of the third and seventh ground selection lines GSL3 and GSL7. In this case, as in the above description, in each unselected cell string, turned-off ground selection transistors may be physically spaced apart from each other. A dummy ground selection transistor may be located between the ground selection transistors spaced apart from each other.

As described above, the ground selection transistors may be programmed based on at least two GST coding patterns, and a plurality of dummy ground selection transistors may be located between the at least two GST coding patterns. In some implementations, the at least two GST coding patterns may have the same pattern. Alternatively, the at least two GST coding patterns may have different patterns.

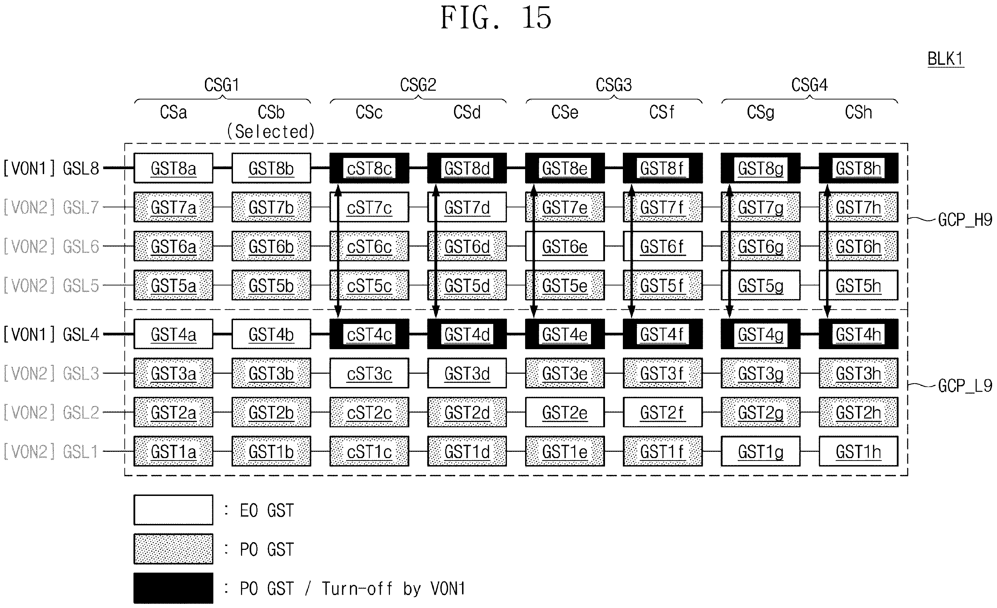

Next, referring to FIGS. 1, 2, and 15, the first memory block BLK1 may include a plurality of cell strings CSa to CSh. The plurality of cell strings CSa to CSh may include a plurality of ground selection transistors GST1a to GST8h. As illustrated in FIG. 15, the first memory block BLK1 may have an 8SSL-1GSL structure. That is, the plurality of cell strings CSa to CSh may be connected to the same bit line and may share the ground selection lines GSL1 to GSL8. Each of the plurality of cell strings CSa to CSh may be individually connected to a string selection line.

In this case, the plurality of cell strings CSa to CSh may be controlled in units of cell string group. For example, a first cell string group CSG1 may include the a-th and b-th cell strings CSa and CSb, a second cell string group CSG2 may include the c-th and d-th cell strings CSc and CSd, a third cell string group CSG3 may include the e-th and f-th cell strings CSe and CSf, and a fourth cell string group CSG4 may include the g-th and h-th cell strings CSg and CSh.

In this case, the plurality of ground selection transistors GST1a to GST4h connected to the first to fourth ground selection lines GSL1 to GSL4 may be programmed based on a ninth lower GST coding pattern GCP_L9, and the plurality of ground selection transistors GST5a to GST8h connected to the fifth to eighth ground selection lines GSL5 to GSL8 may be programmed based on a ninth upper GST coding pattern GCP_H9.

For example, the 4a-th, 4b-th, 3c-th, 3d-th, 2e-th, 2f-th, 1g-th, and 1h-th ground selection transistors GST4a, GST4b, GST3c, GST3d, GST2e, GST2f, GST1g, and GST1h may have the 0-th erase state E0, and the remaining ground selection transistors GST1a, GST1b, GST1c, GST1d, GST1e, GST1f, GST2a, GST2b, GST2c, GST2d, GST2g, GST2h, GST3a, GST3b, GST3e, GST3f, GST3g, GST3h, GST4c, GST4d, GST4e, GST4f, GST4g, and GST4h may have the 0-th program state P0. When the ninth upper GST coding pattern GCP_H9 is used for programming, the 8a-th, 8b-th, 7c-th, 7d-th, 6e-th, 6f-th, 5g-th, and 5h-th ground selection transistors GST8a, GST8b, GST7c, GST7d, GST6e, GST6f, GST5g, and GST5h may have the 0-th erase state E0, and the remaining ground selection transistors GST5a, GST5b, GST5c, GST5d, GST5e, GST5f, GST6a, GST6b, GST6c, GST6d, GST6g, GST6h, GST7a, GST7b, GST7e, GST7f, GST7g, GST7h, GST8c, GST8d, GST8e, GST8f, GST8g, and GST8h may have the 0-th program state P0.

In this case, when the b-th cell string CSb is a selected cell string, the first on-voltage VON1 may be applied to the fourth and eighth ground selection lines GSL4 and GSL8, and the second on-voltage VON2 may be applied to the remaining ground selection lines GSL1, GSL2, GSL3, GSL5, GSL6, and GSL7. According to the bias of the ground selection lines GSL1 to GSL8 of FIG. 15, some ground selection transistors GST4c, GST4d, GST4e, GST4f, GST4g, GST4h, GST5c, GST5d, GST5e, GST5f, GST5g, and GST5h of the cell strings CSc to CSh of unselected cell string groups (e.g., CSG2 to CSG4) may be turned off by the first on-voltages VON1 of the fourth and eighth ground selection lines GSL4 and GSL8. Accordingly, in each of the cell strings CSc to CSh of the unselected cell string groups (e.g., CSG2 to CSG4), the turned-off ground selection transistors may be physically spaced apart from each other.

As described above, ground selection transistors of a memory block may be programmed based on at least two GST coding patterns. The at least two GST coding patterns may be used to program ground selection transistors connected to different ground selection lines. In this case, the at least two GST coding patterns may be set such that the turned-off ground selection transistors of each unselected cell string are physically spaced apart from each other. In this case, the reduction of performance or reliability of the memory device due to the change in threshold voltages of the ground selection transistors may be prevented.

In some implementations, the at least two GST coding patterns may be identical to each other. Alternatively, the at least two GST coding patterns may be different from each other. Alternatively, some of the at least two GST coding patterns may be identical to each other, and the others thereof may be different from each other.

In some implementations, each of the at least two GST coding patterns may be an n-erase pattern (n being a natural number) or an m-program pattern (m being a natural number). The n-erase pattern may refer to a pattern in which n ground selection transistors among a plurality of ground selection transistors of each cell string have the 0-th erase state E0 and the others thereof have the 0-th program state P0. In this case, the n ground selection transistors of the 0-th erase state E0 may be adjacent to each other. Alternatively, at least some of the n ground selection transistors of the 0-th erase state E0 may be spaced apart from each other. The m-erase pattern may refer to a pattern in which m ground selection transistors among a plurality of ground selection transistors of each cell string have the 0-th program state P0 and the others thereof have the 0-th erase state E0. In this case, the m ground selection transistors of the 0-th program state P0 may be adjacent to each other. Alternatively, at least some of the m ground selection transistors of the 0-th program state P0 may be spaced apart from each other.

In some implementations, dummy ground selection transistors connected to a dummy ground selection line may be located between ground selection transistors programmed based on at least two GST coding patterns. In the operation (e.g., the read or program operation) of the memory device 100, all dummy ground selection transistors may be turned on regardless of a selected cell string.

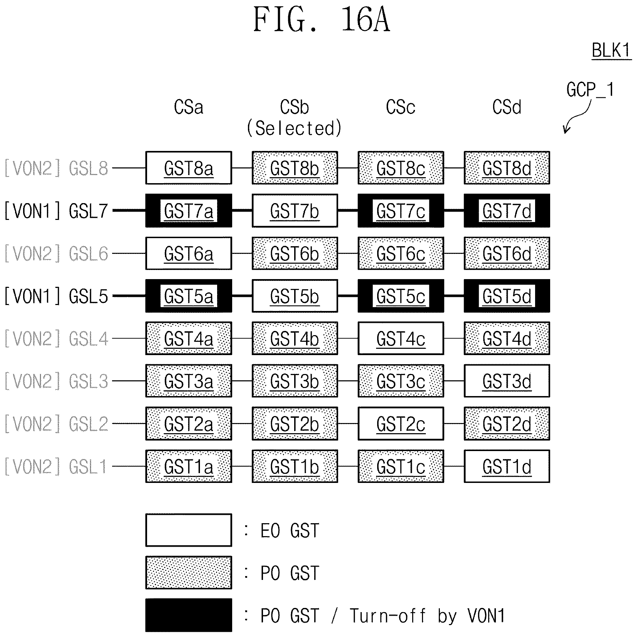

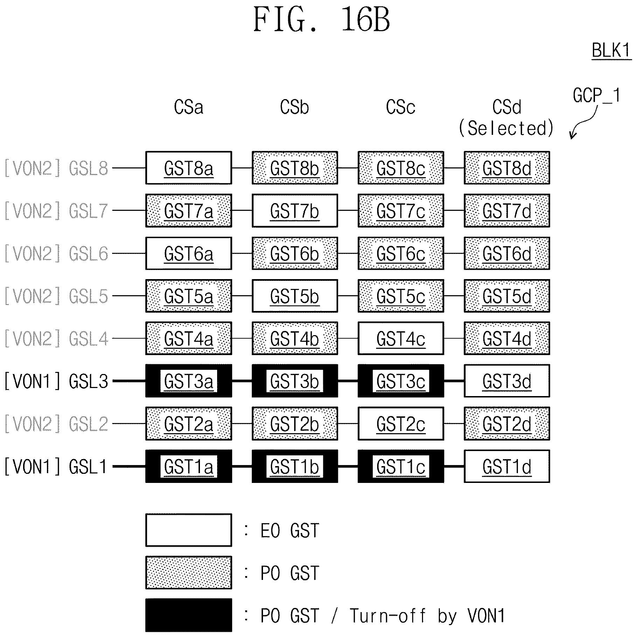

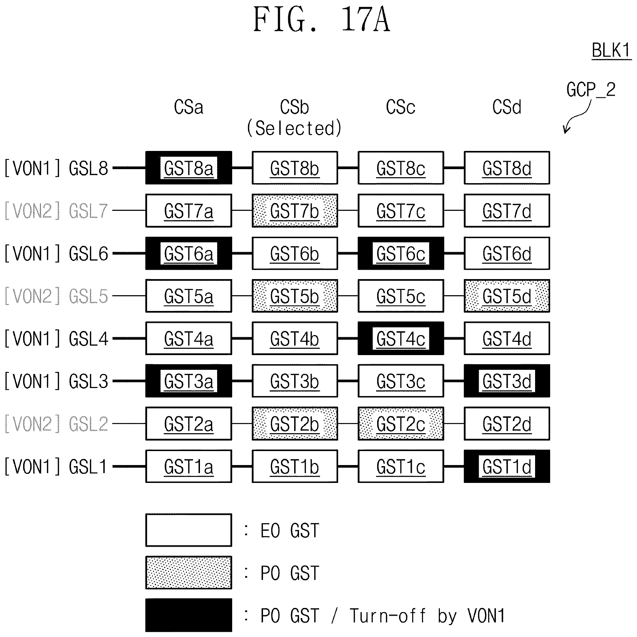

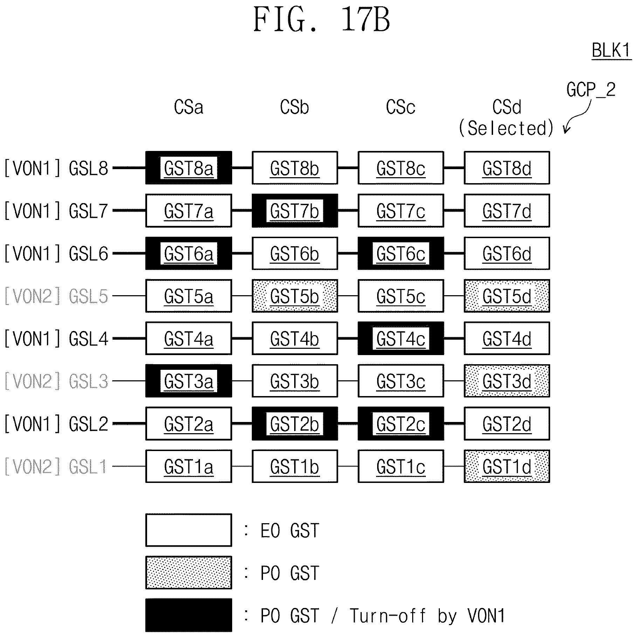

FIGS. 16A, 16B, 17A, and 17B are diagrams for describing an example of a GST coding pattern for ground selection transistors of a memory block of FIG. 2. In the implementations described with reference to FIGS. 5 to 15, the ground selection transistors GST of the first memory block BLK1 are programmed based on at least two GST coding patterns. However, the present disclosure is not limited thereto. For example, the ground selection transistors GST of the first memory block BLK1 may be programmed based on a single GST coding pattern satisfying a specific condition. For example, the specific condition may be as follows.

**[Table 1]**

| Ground selection line | Bias | GST of selected cell string | | GST of unselected cell string | |
|---|---|---|---|---|---|
| | | Vth | On/Off state | Vth | On/Off state |
| GSL_h | VON1 | E0 | ON | P0 | OFF |
| GSL_m | VON2 | P0 | ON | E0 or P0 | ON |
| GSL_1 | VON1 | E0 | ON | P0 | OFF |

Referring to table 1, each of a selected cell string and an unselected cell string includes three ground selection transistors. In the selected cell string, a ground selection transistor connected to the upper ground selection line GSL_h has the 0-th erase state E0, a ground selection transistor connected to the intermediate ground selection line GSL_m has the 0-th program state P0, and a ground selection transistor connected to the lower ground selection line GSL_l has the 0-th erase state E0. In the unselected cell string, a ground selection transistor connected to the upper ground selection line GSL_h has the 0-th program state P0, a ground selection transistor connected to the intermediate ground selection line GSL_m has the 0-th erase state E0 or the 0-th program state P0, and a ground selection transistor connected to the lower ground selection line GSL_1 has the 0-th program state P0. In this case, the upper ground selection line GSL_h, the intermediate ground selection line GSL_m, and the lower ground selection line GSL_l may be adjacent to each other or may be spaced apart from each other. At least one ground selection line may be present between the upper ground selection line GSL_h, the intermediate ground selection line GSL_m, and the lower ground selection line GSL_1.

To electrically connect the selected cell string to the common source line CSL, the first on-voltage VON1 may be applied to the upper ground selection line GSL_h, the second on-voltage VON2 may be applied to the intermediate ground selection line GSL_m, and the first on-voltage VON1 may be applied to the lower ground selection line GSL_1. Accordingly, all the ground selection transistors of the selected cell string may be turned on. In the unselected cell string, the ground selection transistor connected to the upper ground selection line GSL_h may be turned off, the ground selection transistor connected to the intermediate ground selection line GSL_m may be turned on, and the ground selection transistor connected to the lower ground selection line GSL_l may be turned off. According to the condition of table 1, in the unselected cell string, the turned-off ground selection transistors may be physically spaced apart from each.

GST coding patterns GCP_1 and GCP_2 of FIGS. 16A to 17B may be set to satisfy the condition of table 1. For example, referring to FIGS. 16A and 16B, the first memory block BLK1 may include the a-th to d-th cell strings CSa to CSd. The a-th to d-th cell strings CSa to CSd may include the plurality of ground selection transistors GST1a to GST8d.

The plurality of ground selection transistors GST1a to GST8d may be programmed based on the first GST coding pattern GCP_1. In this case, the 8a-th, 6a-th, 7b-th, 5b-th, 4c-th, 2c-th, 3d-th, and 1d-th ground selection transistors GST8a, GST6a, GST7b, GST5b, GST4c, GST2c, GST3d, and GST1d may have the 0-th erase state E0, and may have the remaining ground selection transistors GST1a, GST1b, GST1c, GST2a, GST2b, GST2d, GST3a, GST3b, GST3c, GST4a, GST4b, GST4d, GST5a, GST5c, GST5d, GST6b, GST6c, GST6d, GST7a, GST7c, GST7d, GST8b, GST8c, and GST8d may have the 0-th program state P0.

In this case, as illustrated in FIG. 16A, when the b-th cell string CSb is a selected cell string, the first on-voltage VON1 may be applied to the fifth and seventh ground selection lines GSL5 and GSL7, and the second on-voltage VON2 may be applied to the remaining ground selection lines GSL1, GSL2, GSL3, GSL4, GSL6, and GSL8. In this case, all the ground selection transistors GST1b to GST8b of the b-th cell string CSb being a selected cell string may be turned on. The ground selection transistors GST5a, GST5c, GST5d, GST7a, GST7c, and GST7d of the a-th, c-th, and d-th cell strings CSa, CSc, and CSd being an unselected cell string may be turned off by the first on-voltages VON1 of the fifth and seventh ground selection lines GSL5 and GSL7.

Also, as illustrated in FIG. 16B, when the d-th cell string CSd is a selected cell string, the first on-voltage VON1 may be applied to the first and third ground selection lines GSL1 and GSL3, and the second on-voltage VON2 may be applied to the remaining ground selection lines GSL2, GSL4, GSL5, GSL6, GSL7, and GSL8. In this case, all the ground selection transistors GST1d to GST8d of the d-th cell string CSd being a selected cell string may be turned on. The ground selection transistors GST1a, GST1b, GST1c, GST3a, GST3b, and GST3c of the a-th, b-th, and c-th cell strings CSa, CSb, and CSc being an unselected cell string may be turned off by the first on-voltages VON1 of the first and third ground selection lines GSL1 and GSL3.

As illustrated in FIGS. 16A and 16B, in the unselected cell string, the turned-off ground selection transistors may be physically spaced apart from each other.

For example, referring to FIGS. 17A and 17B, the first memory block BLK1 may include the a-th to d-th cell strings CSa to CSd. The a-th to d-th cell strings CSa to CSd may include the plurality of ground selection transistors GST1a to GST8d.

The plurality of ground selection transistors GST1a to GST8d may be programmed based on the second GST coding pattern GCP_2. In this case, some ground selection transistors GST7a, GST5a, GST4a, GST2a, GST1a, GST8b, GST6b, GST4b, GST3b, GST1b, GST8c, GST7c, GST5c, GST3c, GST1c, GST8d, GST7d, GST6d, GST4d, and GST2d may have the 0-th erase state E0, and the remaining ground selection transistors GST8a, GST6a, GST3a, GST7b, GST5b, GST2b, GST6c, GST4c, GST2c, GST5d, GST3d, and GST1d may have the 0-th program state P0.

In this case, as illustrated in FIG. 17A, it is assumed that the b-th cell string CSb is a selected cell string. In this case, the first on-voltage VON1 may be applied to the first, third, fourth, sixth, and eighth ground selection lines GSL1, GSL3, GSL4, GSL6, and GLS8, and the second on-voltage VON2 may be applied to the remaining ground selection lines GSL2, GSL5, and GSL7.

In this case, all the ground selection transistors GST1b to GST8b of the b-th cell string CSb being a selected cell string may be turned on. The ground selection transistors GST8a, GST6a, GST3a, GST6c, GST4c, GST3d, and GST1d of the a-th, c-th, and d-th cell strings CSa, CSc, and CSd being an unselected cell string may be turned off by the first on-voltage VON1of the first, third, fourth, sixth, and eighth ground selection lines GSL1, GSL3, GSL4, GSL6, and GLS8.

Also, as illustrated in FIG. 17B, when the d-th cell string CSd is a selected cell string, the first on-voltage VON1 may be applied to the second, fourth, sixth, seventh, and eighth ground selection lines GSL2, GSL4, GSL6, GSL7, and GSL8, and the second on-voltage VON2 may be applied to the remaining ground selection lines GSL1, GSL3, and GSL5. In this case, all the ground selection transistors GST1d to GST8d of the d-th cell string CSd being a selected cell string may be turned on. The ground selection transistors GST3a, GST6a, GST8a, GST2b, GST7b, GST2c, GST4c, and GST6c of the a-th, b-th, and c-th CSa, CSb, and CSc being an unselected cell string may be turned off by the first on-voltages VON1 of the second, fourth, sixth, seventh, and eighth ground selection lines GSL2, GSL4, GSL6, GSL7, and GSL8.

As illustrated in FIGS. 17A and 17B, in each unselected cell string, the turned-off ground selection transistors may be physically spaced apart from each other.

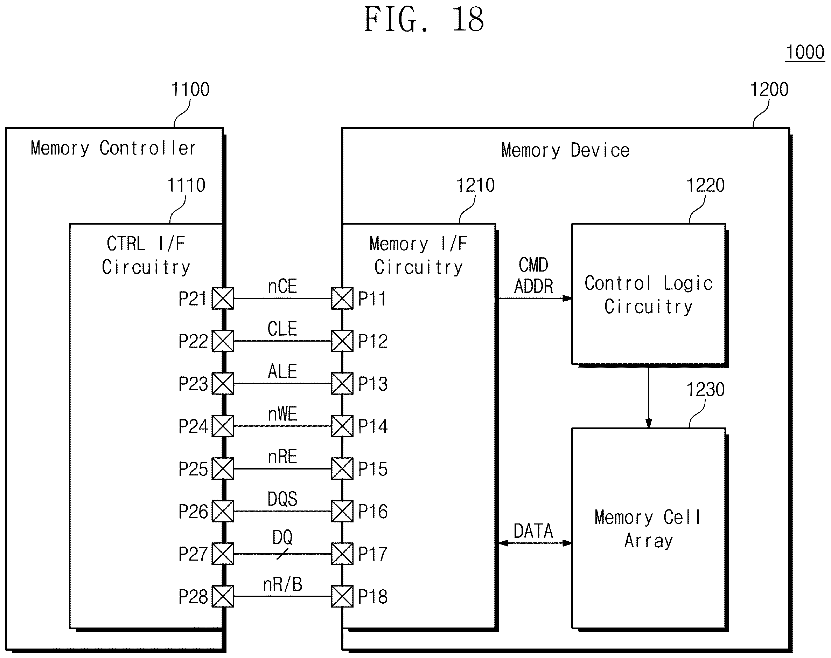

FIG. 18 is a block diagram of an example of a memory system. Referring to FIG. 18, the memory system 1000 may include a memory device 1200 and a memory controller 1100.

The memory device 1200 may include first to eighth pins P11 to P18, a memory interface circuitry 1210, a control logic circuitry 1220, and a memory cell array 1230.

The memory interface circuitry 1210 may receive a chip enable signal nCE from the memory controller 1100 through the first pin P11. The memory interface circuitry 1210 may transmit and receive signals to and from the memory controller 1100 through the second to eighth pins P12 to P18 in response to the chip enable signal nCE. For example, when the chip enable signal nCE is in an enable state (e.g., a low level), the memory interface circuitry 1210 may transmit and receive signals to and from the memory controller 1100 through the second to eighth pins P12 to P18.

The memory interface circuitry 1210 may receive a command latch enable signal CLE, an address latch enable signal ALE, and a write enable signal nWE from the memory controller 1100 through the second to fourth pins P12 to P14. The memory interface circuitry 1210 may receive a data signal DQ from the memory controller 1100 through the seventh pin P17 or transmit the data signal DQ to the memory controller 1100. A command CMD, an address ADDR, and data may be transmitted via the data signal DQ. For example, the data signal DQ may be transmitted through a plurality of data signal lines. In this case, the seventh pin P17 may include a plurality of pins respectively corresponding to a plurality of data signals DQ(s).

The memory interface circuitry 1210 may obtain the command CMD from the data signal DQ, which is received in an enable section (e.g., a high-level state) of the command latch enable signal CLE based on toggle time points of the write enable signal nWE. The memory interface circuitry 1210 may obtain the address ADDR from the data signal DQ, which is received in an enable section (e.g., a high-level state) of the address latch enable signal ALE based on the toggle time points of the write enable signal nWE.

In an example implementation, the write enable signal nWE may be maintained at a static state (e.g., a high level or a low level) and toggle between the high level and the low level. For example, the write enable signal nWE may toggle in a section in which the command CMD or the address ADDR is transmitted. Thus, the memory interface circuitry 1210 may obtain the command CMD or the address ADDR based on toggle time points of the write enable signal nWE.

The memory interface circuitry 1210 may receive a read enable signal nRE from the memory controller 1100 through the fifth pin P15. The memory interface circuitry 1210 may receive a data strobe signal DQS from the memory controller 1100 through the sixth pin P16 or transmit the data strobe signal DQS to the memory controller 1100.

In a data (DATA) output operation of the memory device 1200, the memory interface circuitry 1210 may receive the read enable signal nRE, which toggles through the fifth pin P15, before outputting the data DATA. The memory interface circuitry 1210 may generate the data strobe signal DQS, which toggles based on the toggling of the read enable signal nRE. For example, the memory interface circuitry 1210 may generate a data strobe signal DQS, which starts toggling after a predetermined delay (e.g., tDQSRE), based on a toggling start time of the read enable signal nRE. The memory interface circuitry 1210 may transmit the data signal DQ including the data DATA based on a toggle time point of the data strobe signal DQS. Thus, the data DATA may be aligned with the toggle time point of the data strobe signal DQS and transmitted to the memory controller 1100.

In a data (DATA) input operation of the memory device 1200, when the data signal DQ including the data DATA is received from the memory controller 1100, the memory interface circuitry 1210 may receive the data strobe signal DQS, which toggles, along with the data DATA from the memory controller 1100. The memory interface circuitry 1210 may obtain the data DATA from the data signal DQ based on toggle time points of the data strobe signal DQS. For example, the memory interface circuitry 1210 may sample the data signal DQ at rising and falling edges of the data strobe signal DQS and obtain the data DATA.

The memory interface circuitry 1210 may transmit a ready/busy output signal nR/B to the memory controller 1100 through the eighth pin P18. The memory interface circuitry 1210 may transmit state information of the memory device 1200 through the ready/busy output signal nR/B to the memory controller 1100. When the memory device 1200 is in a busy state (i.e., when operations are being performed in the memory device 1200), the memory interface circuitry 1210 may transmit a ready/busy output signal nR/B indicating the busy state to the memory controller 1100. When the memory device 1200 is in a ready state (i.e., when operations are not performed or completed in the memory device 1200), the memory interface circuitry 1210 may transmit a ready/busy output signal nR/B indicating the ready state to the memory controller 1100. For example, while the memory device 1200 is reading data DATA from the memory cell array 1230 in response to a page read command, the memory interface circuitry 1210 may transmit a ready/busy output signal nR/B indicating a busy state (e.g., a low level) to the memory controller 1100. For example, while the memory device 1200 is programming data DATA to the memory cell array 1230 in response to a program command, the memory interface circuitry 1210 may transmit a ready/busy output signal nR/B indicating the busy state to the memory controller 1100.

The control logic circuitry 1220 may control all operations of the memory device 1200. The control logic circuitry 1220 may receive the command/address CMD/ADDR obtained from the memory interface circuitry 1210. The control logic circuitry 1220 may generate control signals for controlling other components of the memory device 1200 in response to the received command/address CMD/ADDR. For example, the control logic circuitry 1220 may generate various control signals for programming data DATA to the memory cell array 1230 or reading the data DATA from the memory cell array 1230.

The memory cell array 1230 may store the data DATA obtained from the memory interface circuitry 1210, via the control of the control logic circuitry 1220. The memory cell array 1230 may output the stored data DATA to the memory interface circuitry 1210 via the control of the control logic circuitry 1220.

The memory cell array 1230 may include a plurality of memory cells. For example, the plurality of memory cells may be flash memory cells. However, the present disclosure is not limited thereto, and the memory cells may be RRAM cells, FRAM cells, PRAM cells, thyristor RAM (TRAM) cells, or MRAM cells. Hereinafter, an implementation in which the memory cells are NAND flash memory cells will mainly be described.

The memory controller 1100 may include first to eighth pins P21 to P28 and a controller interface circuitry 1110. The first to eighth pins P21 to P28 may respectively correspond to the first to eighth pins P11 to P18 of the memory device 1200.

The controller interface circuitry 1110 may transmit a chip enable signal nCE to the memory device 1200 through the first pin P21. The controller interface circuitry 1110 may transmit and receive signals to and from the memory device 1200, which is selected by the chip enable signal nCE, through the second to eighth pins P22 to P28.

The controller interface circuitry 1110 may transmit the command latch enable signal CLE, the address latch enable signal ALE, and the write enable signal nWE to the memory device 1200 through the second to fourth pins P22 to P24. The controller interface circuitry 1110 may transmit or receive the data signal DQ to and from the memory device 1200 through the seventh pin P27.

The controller interface circuitry 1110 may transmit the data signal DQ including the command CMD or the address ADDR to the memory device 1200 along with the write enable signal nWE, which toggles. The controller interface circuitry 1110 may transmit the data signal DQ including the command CMD to the memory device 1200 by transmitting a command latch enable signal CLE having an enable state. Also, the controller interface circuitry 1110 may transmit the data signal DQ including the address ADDR to the memory device 1200 by transmitting an address latch enable signal ALE having an enable state.

The controller interface circuitry 1110 may transmit the read enable signal nRE to the memory device 1200 through the fifth pin P25. The controller interface circuitry 1110 may receive or transmit the data strobe signal DQS from or to the memory device 1200 through the sixth pin P26.

In a data (DATA) output operation of the memory device 1200, the controller interface circuitry 1110 may generate a read enable signal nRE, which toggles, and transmit the read enable signal nRE to the memory device 1200. For example, before outputting data DATA, the controller interface circuitry 1110 may generate a read enable signal nRE, which is changed from a static state (e.g., a high level or a low level) to a toggling state. Thus, the memory device 1200 may generate a data strobe signal DQS, which toggles, based on the read enable signal nRE. The controller interface circuitry 1110 may receive the data signal DQ including the data DATA along with the data strobe signal DQS, which toggles, from the memory device 1200. The controller interface circuitry 1110 may obtain the data DATA from the data signal DQ based on a toggle time point of the data strobe signal DQS.

In a data (DATA) input operation of the memory device 1200, the controller interface circuitry 1110 may generate a data strobe signal DQS, which toggles. For example, before transmitting data DATA, the controller interface circuitry 1110 may generate a data strobe signal DQS, which is changed from a static state (e.g., a high level or a low level) to a toggling state. The controller interface circuitry 1110 may transmit the data signal DQ including the data DATA to the memory device 1200 based on toggle time points of the data strobe signal DQS.

The controller interface circuitry 1110 may receive a ready/busy output signal nR/B from the memory device 1200 through the eighth pin P28. The controller interface circuitry 1110 may determine state information of the memory device 1200 based on the ready/busy output signal nR/B.

In some implementations, the memory device 1200 may be implemented with the memory device 100 described with reference to FIGS. 1 to 17B. The memory cell array 1230 of the memory device 1200 may include a plurality of memory blocks, and each of the plurality of memory blocks may include a plurality of ground selection transistors. The plurality of ground selection transistors may be programmed based on the GST coding pattern described with reference to FIGS. 1 to 17B.

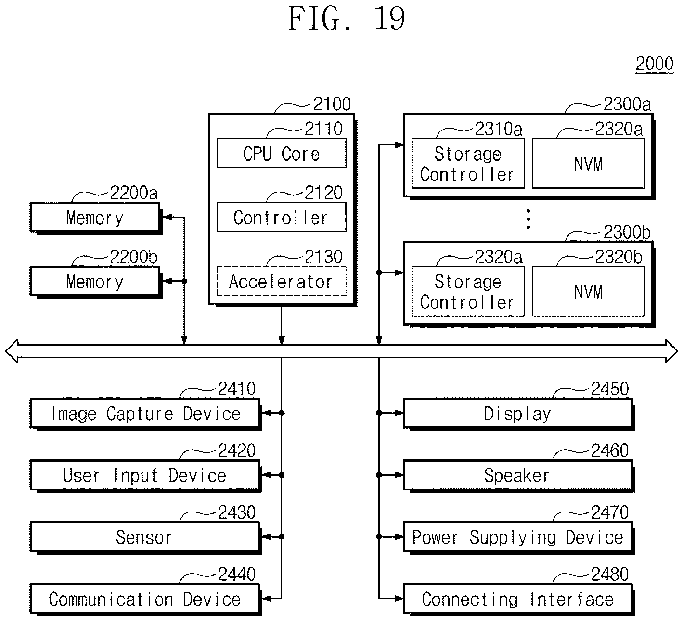

FIG. 19 is a diagram of an example of a system 2000 to which a storage device is applied. The system 2000 of FIG. 19 may basically be a mobile system, such as a portable communication terminal (e.g., a mobile phone), a smartphone, a tablet personal computer (PC), a wearable device, a healthcare device, or an Internet of things (IOT) device. However, the system 2000 of FIG. 19 is not necessarily limited to the mobile system and may be a PC, a laptop computer, a server, a media player, or an automotive device (e.g., a navigation device).

Referring to FIG. 19, the system 2000 may include a main processor 200, memories (e.g., 2200a and 2200b), and storage devices (e.g., 2300a and 2300b). In addition, the system 2000 may include at least one of an image capturing device 2410, a user input device 2420, a sensor 2430, a communication device 2440, a display 2450, a speaker 2460, a power supplying device 2470, and a connecting interface 2480.

The main processor 2100 may control all operations of the system 2000, more specifically, operations of other components included in the system 2000. The main processor 2100 may be implemented as a general-purpose processor, a dedicated processor, or an application processor.

The main processor 2100 may include at least one CPU core 2110 and further include a controller 2120 configured to control the memories 2200a and 2200b and/or the storage devices 2300a and 2300b. In some implementations, the main processor 2100 may further include an accelerator 2130, which is a dedicated circuit for a high-speed data operation, such as an artificial intelligence (AI) data operation. The accelerator 2130 may include a graphics processing unit (GPU), a neural processing unit (NPU) and/or a data processing unit (DPU) and be implemented as a chip that is physically separate from the other components of the main processor 2100.

The memories 2200a and 2200b may be used as main memory devices of the system 1000. Although each of the memories 2200a and 2200b may include a volatile memory, such as static random access memory (SRAM) and/or dynamic RAM (DRAM), each of the memories 2200a and 2200b may include non-volatile memory, such as a flash memory, phase-change RAM (PRAM) and/or resistive RAM (RRAM). The memories 2200a and 2200b may be implemented in the same package as the main processor 2100.

The storage devices 2300a and 2300b may serve as non-volatile storage devices configured to store data regardless of whether power is supplied thereto, and have larger storage capacity than the memories 2200a and 2200b. The storage devices 2300a and 2300b may respectively include storage controllers (STRG CTRL) 2310a and 2310b and NVM (Non-Volatile Memory)s 2320a and 2320b configured to store data via the control of the storage controllers 2310a and 2310b. Although the NVMs 2320a and 2320b may include flash memories having a two-dimensional (2D) structure or a three-dimensional (3D) V-NAND structure, the NVMs 2320a and 2320b may include other types of NVMs, such as PRAM and/or RRAM.

The storage devices 2300a and 2300b may be physically separated from the main processor 2100 and included in the system 2000 or implemented in the same package as the main processor 2100. In addition, the storage devices 2300a and 2300b may have types of solid-state devices (SSDs) or memory cards and be removably combined with other components of the system 2000 through an interface, such as the connecting interface 2480 that will be described below. The storage devices 2300a and 2300b may be devices to which a standard protocol, such as a universal flash storage (UFS), an embedded multi-media card (eMMC), or a non-volatile memory express (NVMe), is applied, without being limited thereto.

The image capturing device 2410 may capture still images or moving images. The image capturing device 2410 may include a camera, a camcorder, and/or a webcam.

The user input device 2420 may receive various types of data input by a user of the system 2000 and include a touch pad, a keypad, a keyboard, a mouse, and/or a microphone.

The sensor 2430 may detect various types of physical quantities, which may be obtained from the outside of the system 2000, and convert the detected physical quantities into electric signals. The sensor 2430 may include a temperature sensor, a pressure sensor, an illuminance sensor, a position sensor, an acceleration sensor, a biosensor, and/or a gyroscope sensor.

The communication device 2440 may transmit and receive signals between other devices outside the system 2000 according to various communication protocols. The communication device 2440 may include an antenna, a transceiver, and/or a modem.

The display 2450 and the speaker 2460 may serve as output devices configured to respectively output visual information and auditory information to the user of the system 2000.

The power supplying device 2470 may appropriately convert power supplied from a battery embedded in the system 2000 and/or an external power source, and supply the converted power to each of components of the system 2000.

The connecting interface 2480 may provide connection between the system 2000 and an external device, which is connected to the system 2000 and capable of transmitting and receiving data to and from the system 2000. The connecting interface 2480 may be implemented by using various interface schemes, such as advanced technology attachment (ATA), serial ATA (SATA), external SATA (e-SATA), small computer small interface (SCSI), serial attached SCSI (SAS), peripheral component interconnection (PCI), PCI express (PCIe), NVMe, IEEE 1394, a universal serial bus (USB) interface, a secure digital (SD) card interface, a multi-media card (MMC) interface, an eMMC interface, a UFS interface, an embedded UFS (eUFS) interface, and a compact flash (CF) card interface.

In some implementations, the non-volatile memory 2320a and 2320b of the storage devices 2300a and 2300b of FIG. 19 may include the memory device described with reference to FIGS. 1 to 17B.

According to the present disclosure, in an unselected cell string of a memory device, turned-off ground selection transistors may be physically spaced apart from each other. Accordingly, the reliability and performance of the memory device may be improved.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While the present disclosure has been described with reference to implementations thereof, it will be apparent to those of ordinary skill in the art that various changes and modifications may be made thereto without departing from the spirit and scope of the present disclosure as set forth in the following claims.

## Claims

1. A memory device comprising:
a substrate;
a first cell string on the substrate between a first bit line and a common source line, the first cell string including a first string selection transistor connected to a first string selection line; and
a second cell string on the substrate between the first bit line and the common source line, the second cell string including a second string selection transistor connected to a second string selection line,
wherein the first cell string includes:
a first ground selection transistor connected to a first ground selection line; and
a third ground selection transistor connected to a second ground selection line and spaced apart from the first ground selection transistor,
wherein the second cell string includes:
a second ground selection transistor connected to the first ground selection line; and
a fourth ground selection transistor connected to the second ground selection line and spaced apart from the second ground selection transistor, and
wherein, when the first cell string is a selected cell string, the second ground selection transistor and the fourth ground selection transistor in the second cell string are configured to be turned off, and at least one ground selection transistor between the second ground selection transistor and the fourth ground selection transistor in the second cell string is configured to be turned on.

2. The memory device of claim 1, wherein the first cell string includes:
a fifth ground selection transistor connected to a third ground selection line; and
a seventh ground selection transistor connected to a fourth ground selection line,
wherein the second cell string includes:
a sixth ground selection transistor connected to the third ground selection line, and
an eighth ground selection transistor connected to the fourth ground selection line,
wherein the third ground selection line is between the first ground selection line and the second ground selection line, and
wherein the second ground selection line is between the third ground selection line and the fourth ground selection line.

3. The memory device of claim 2, wherein, when the second cell string is the selected cell string, the fifth ground selection transistor and the seventh ground selection transistor in the first cell string are configured to be turned off, and at least one ground selection transistor between the fifth ground selection transistor and the seventh ground selection transistor in the first cell string is configured to be turned on.

4. The memory device of claim 3, wherein the memory device includes:
a third cell string on the substrate between the first bit line and the common source line, the third cell string including a third string selection transistor connected to a third string selection line, and
wherein the third cell string includes:
a ninth ground selection transistor connected to the first ground selection line;
a tenth ground selection transistor connected to the second ground selection line;
an eleventh ground selection transistor connected to the third ground selection line; and
a twelfth ground selection transistor connected to the fourth ground selection line.

5. The memory device of claim 4, wherein, when the first cell string is the selected cell string, the ninth ground selection transistor and the tenth ground selection transistor in the third cell string are configured to be turned off, and at least one ground selection transistor between the ninth ground selection transistor and the tenth ground selection transistor in the third cell string is configured to be turned on.

6. The memory device of claim 4, wherein, when the second cell string is the selected cell string, the eleventh ground selection transistor and the twelfth ground selection transistor in the third cell string are configured to be turned off, and at least one ground selection transistor between the eleventh ground selection transistor and the twelfth ground selection transistor in the third cell string is configured to be turned on.

7. The memory device of claim 4, wherein the third cell string includes:
a thirteenth ground selection transistor connected to a fifth ground selection line; and
a fourteenth ground selection transistor connected to a sixth ground selection line,
wherein the fifth ground selection line is between the second ground selection line and the third ground selection line, and
wherein the second ground selection line and the fourth ground selection line are positioned between the fifth ground selection line and the sixth ground selection line.

8. The memory device of claim 7, wherein, when the first cell string or the second cell string is the selected cell string, the thirteenth ground selection transistor and the fourteenth ground selection transistor in the third cell string are configured to be turned off, and at least one ground selection transistor between the thirteenth ground selection transistor and the fourteenth ground selection transistor in the third cell string is configured to be turned on.

9. The memory device of claim 2, wherein a first threshold voltage state of the first ground selection transistor is lower than a second threshold voltage state of the second ground selection transistor,
wherein a third threshold voltage state of the third ground selection transistor is lower than a fourth threshold voltage state of the fourth ground selection transistor,
wherein a fifth threshold voltage state of the fifth ground selection transistor is higher than a sixth threshold voltage state of the sixth ground selection transistor, and
wherein a seventh threshold voltage state of the seventh ground selection transistor is higher than an eighth threshold voltage state of the eighth ground selection transistor.

10. The memory device of claim 9, wherein, when the first cell string is the selected cell string, the memory device is configured to
apply a first voltage to the first ground selection line,
apply a second voltage to the second ground selection line,
apply a third voltage to the third ground selection line, and
apply a fourth voltage to the fourth ground selection line,
wherein the first voltage is higher than the first threshold voltage state and is lower than the second threshold voltage state,
wherein the second voltage is higher than the third threshold voltage state and is lower than the fourth threshold voltage state,
wherein the third voltage is higher than the fifth threshold voltage state, and
wherein the fourth voltage is higher than the seventh threshold voltage state.

11. The memory device of claim 10, wherein the first voltage is same as the second voltage, and
wherein the third voltage is same as the fourth voltage.

12. The memory device of claim 9, wherein the first threshold voltage state, the third threshold voltage state, the sixth threshold voltage state, and the eighth threshold voltage state are the same, and
wherein the second threshold voltage state, the fourth threshold voltage state, the fifth threshold voltage state, and the seventh threshold voltage state are the same.

13. The memory device of claim 9, wherein the second threshold voltage state is different from the fourth threshold voltage state, and
wherein the fifth threshold voltage state is different from the seventh threshold voltage state.

14. The memory device of claim 1, wherein a dummy ground selection line is between the first ground selection line and the second ground selection line,
wherein the first cell string includes a first dummy ground selection transistor connected to the dummy ground selection line, and
wherein the second cell string includes a second dummy ground selection transistor connected to the dummy ground selection line.

15. The memory device of claim 14, wherein, when the first cell string or the second cell string is the selected cell string, the first dummy ground selection transistor and the second dummy ground selection transistor are configured to be turned on.
